(19)

Europäisches
Patentamt
European
Patent Office
Office européen
des brevets

(11) **EP 1 811 327 A1**

(12) **EUROPEAN PATENT APPLICATION**
published in accordance with Art. 158(3) EPC

(43) Date of publication:
**25.07.2007 Bulletin 2007/30**

(51) Int Cl.:
***G02B 17/00*** (2006.01)

(21) Application number: **05800551.3**

(22) Date of filing: **04.11.2005**

(86) International application number:
**PCT/JP2005/020267**

(87) International publication number:
**WO 2006/049233 (11.05.2006 Gazette 2006/19)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **05.11.2004 JP 2004322282**

(71) Applicant: **NIKON CORPORATION**
**Tokyo 100-8331 (JP)**

(72) Inventor: **TAKAHASHI, Tomowaki,**
**c/o NIKON CORPORATION**
**Tokyo 100-8331 (JP)**

(74) Representative: **Hooiveld, Arjen Jan Winfried et al**
**Arnold & Siedsma**
**Sweelinckplein 1**
**2517 GK Den Haag (NL)**

(54) **REFLECTION-TYPE PROJECTION OPTICAL SYSTEM AND EXPOSURE EQUIPMENT PROVIDED WITH SUCH REFLECTION-TYPE PROJECTION OPTICAL SYSTEM**

(57) A projection optical system has eight reflecting mirrors and is adapted to form a reduced image of a first surface on a second surface. The projection optical system has a first imaging catoptric system (G1) for forming an intermediate image of the first surface, and a second imaging catoptric system (G2) for forming an image of the intermediate image on the second surface. The first imaging catoptric system has a first reflecting mirror (M1), a second reflecting mirror (M2), a third reflecting mirror (M3), and a fourth reflecting mirror (M4) in an order of incidence of light from the first surface side. The second imaging catoptric system has a fifth reflecting mirror (M5), a sixth reflecting mirror (M6), a seventh reflecting mirror (M7), and an eighth reflecting mirror (M8) in an order of incidence of light from the first surface side. At least one reflecting surface among the eight reflecting mirrors is comprised of a spherical surface.

*Fig.3*

**Description**

**Technical Field**

The present invention relates to a reflective projection optical system, and an exposure apparatus with the reflective projection optical system, and, for example, relates to a reflection type projection optical system suitably applicable to X-ray projection exposure apparatus for transferring a circuit pattern on a mask onto a photosensitive substrate by the mirror projection method with X-rays (EUV light).

**Background Art**

The conventional exposure apparatus used for fabrication of semiconductor devices and the like is arranged to project and transfer a circuit pattern formed on a mask (reticle), through a projection optical system onto a photosensitive substrate such as a wafer. The photosensitive substrate is coated with a resist, and the resist is exposed to projection exposure light guided through the projection optical system, to obtain a resist pattern corresponding to the mask pattern. The resolving power W of the exposure apparatus is dependent upon the wavelength $\lambda$ of the exposure light and the numerical aperture NA of the projection optical system and is expressed by Eq. (a) below.

$$W = K \cdot \lambda \, / \, NA \, (K: \text{constant}) \quad (a)$$

Therefore, in order to improve the resolving power of the exposure apparatus, it is necessary to decrease the wavelength $\lambda$ of the exposure light or to increase the numerical aperture NA of the projection optical system. In general, it is difficult in terms of optical design to increase the numerical aperture NA of the projection optical system over a predetermined value, and thus it will be necessary to further decrease the wavelength of the exposure light. For example, when the exposure light is a KrF excimer laser with the wavelength of 248 nm, the resolving power achieved is 0.25 $\mu$m; when the exposure light is an ArF excimer laser with the wavelength of 193 nm, the resolving power achieved is 0.1 $\mu$ m or less, for example, at the wavelength of 13 nm.

Incidentally, when X-rays are used as the exposure light, there is neither a transmitting optical material nor a refracting optical material available, and it would lead to use of a reflective mask and use of a reflective projection optical system. The conventional projection optical systems applicable to the exposure apparatus using X-rays as the exposure light include a variety of reflective projection optical systems as proposed, for example, in Japanese Patent Application Laid-open No. 9-211332 (application corresponding to U. S. Pat. No. 5,815,310), Japanese Patent Application Laid-open No. 2002-139672 (application corresponding to U. S. Pat. No. 6,710,917), and so on.

**Disclosure of the Invention**

**Problems to be Solved by the Invention**

In the reflective projection optical system disclosed in U. S. Pat. No. 5,815,310 as a conventional example of the reflective projection optical system composed of six reflecting mirrors, however, the six reflecting mirrors all are configured with a reflecting surface of an aspherical shape, and thus fabrication thereof requires such steps as normal aspheric processing (grinding, polishing) and measurement, necessitating a lot of labor, time, and cost.

In the reflective projection optical system disclosed in U. S. Pat. No. 6,710,917 as a conventional example of the reflective projection optical system composed of eight reflecting mirrors, the sixth reflecting mirror among the eight reflecting mirrors is formed as a spherical surface. This example of U. S. Pat. No. 6,710,917 adopts the optical system having two intermediate images between the second and third reflecting mirrors and between the sixth and seventh reflecting mirrors, and the sixth reflecting mirror is a reflector having a use region (which is a region where rays contributing to imaging are reflected on the reflector, and which is also called an effective region) at the most distant position from the axis. When the sixth reflecting mirror with the use region distant from the optical axis is formed as a spherical surface, it becomes easier to inspect the sixth reflecting mirror with an interferometer. The reason is that inspection of asphericity with the interferometer becomes harder as the use region is located farther off the optical axis.

However, the reflective projection optical system has the problem that the effective diameter of the sixth reflecting mirror becomes as large as near 800mm. In addition, it adopts the thrice imaging system with two intermediate images Z1, Z2 in order to secure the use region close to the axis for as many reflecting mirrors as possible. For this reason, the distance from the object to the image (object-image distance) inevitably becomes as long as near 2 m and it also has the problem that the entire optical system becomes larger in scale. Since each reflecting mirror under a stricter requirement for manufacturing error is an aspherical surface, the projection optical system, when actually fabricated, is likely to give rise to aberration due to manufacturing error, and there is another problem that it is difficult to fabricate the projection optical system as designed.

The present invention has been accomplished in view of the above-described problems and an object of the present invention is to provide a reflection type projection optical system having eight reflecting mirrors at least one of surfaces of which is formed in a spherical shape and adopting a twice imaging system to reduce the sizes of the reflecting mirrors and the total length of the optical system and to drastically curtail the time and cost necessary for fabrication. Another object of the present invention is to provide a projection optical system in which the requirement for manufacturing error is relatively relaxed. Still another object of the present invention is to provide an exposure apparatus to which the projection optical system of the present invention is applied, so that it can ensure a high resolving power, for example, using X-rays as exposure light.

**Means for Solving the Problems**

In order to solve the above problems, a first aspect of the present invention provides a reflective projection optical system comprising eight reflecting mirrors and adapted to form a reduced image of a first surface on a second surface, the reflective projection optical system comprising: a first imaging catoptric system for forming an intermediate image of the first surface; and a second imaging catoptric system for forming an image of the intermediate image on the second surface; wherein the first imaging catoptric system has a first reflecting mirror M1, a second reflecting mirror M2, a third reflecting mirror M3, and a fourth reflecting mirror M4 in an order of incidence of light from the first surface side; wherein the second imaging catoptric system has a fifth reflecting mirror M5, a sixth reflecting mirror M6, a seventh reflecting mirror M7, and an eighth reflecting mirror M8 in an order of incidence of light from the first surface side, wherein at least one reflecting surface among the eight reflecting mirrors is comprised of a spherical surface, and wherein the other reflecting surfaces are comprised of aspherical surfaces. The projection optical system achieves reduction in the maximum effective diameter of the reflecting mirrors constituting the projection optical system and in the total length of the optical system, and prevents increase in the size of apparatus.

A second aspect of the present invention provides an exposure apparatus comprising: an illumination system for illuminating a mask set on the first surface; and the reflective projection optical system of the first aspect for projecting a pattern of the mask onto a photosensitive substrate set on the second surface, to effect exposure thereof. In a preferred embodiment of the second aspect, the illumination system comprises a light source for supplying X-rays as exposure light, and the projection exposure of the pattern of the mask is effected on the photosensitive substrate, with relative movement of the mask and the photosensitive substrate to the reflective projection optical system.

**Effect of the Invention**

The reflective projection optical system of the present invention adopts the twice imaging optical system comprising the reflecting mirrors at least one of surfaces of which is formed in the spherical shape, whereby it achieves reduction in the size of the reflecting mirrors and in the total length of the optical system, permits relatively easy processing (grinding, polishing) and measurement of the surfaces of the reflecting mirrors, assembly, and adjustment, and drastically curtails the time and cost for fabrication. In the reflective projection optical system of the present invention, the surface of the reflecting mirror with a relatively high requirement for manufacturing error is formed in the spherical shape among at least eight reflecting mirrors, whereby the reflective optical system with high accuracy requirements can be relatively readily fabricated.

By applying the reflective projection optical system of the present invention to the exposure apparatus, it becomes feasible to use X-rays as exposure light. In this case, the mask and the photosensitive substrate are moved relative to the projection optical system to effect the projection exposure of the pattern of the mask on the photosensitive substrate. As a result, highly accurate micro devices can be produced under a good exposure condition, using the scanning exposure apparatus with a high resolving power.

**Brief Description of the Drawings**

Fig. 1 is a drawing schematically showing a configuration of an exposure apparatus according to an embodiment of the present invention.
Fig. 2 is a drawing showing a positional relation between an arcuate exposure region (or effective exposure region) formed on a wafer, and the optical axis.
Fig. 3 is a drawing showing a configuration of a projection optical system according to the first example of the embodiment.

Fig. 4 is a drawing showing coma in the projection optical system of the first example.

Fig. 5 is a drawing showing a configuration of a projection optical system according to the second example of the embodiment.

Fig. 6 is a drawing showing coma in the projection optical system of the second example.

Fig. 7 is a drawing showing a configuration of a projection optical system according to the third example of the embodiment.

Fig. 8 is a drawing showing coma in the projection optical system of the third example.

Fig. 9 is a drawing showing a configuration of a projection optical system according to the fourth example of the embodiment.

Fig. 10 is a drawing showing coma in the projection optical system of the fourth example.

Fig. 11 is a drawing showing a configuration of a projection optical system according to the fifth example of the embodiment.

Fig. 12 is a drawing showing coma in the projection optical system of the fifth example.

Fig. 13 is a drawing showing a configuration of a projection optical system according to the sixth example of the embodiment.

Fig. 14 is a drawing showing coma in the projection optical system of the sixth example.

Fig. 15 is a drawing showing a configuration of a projection optical system according to the seventh example of the embodiment.

Fig. 16 is a drawing showing coma in the projection optical system of the seventh example.

Fig. 17 is a drawing showing a configuration of a projection optical system according to the eighth example of the embodiment.

Fig. 18 is a drawing showing coma in the projection optical system of the eighth example.

Fig. 19 is a drawing showing a configuration of a projection optical system according to the ninth example of the embodiment.

Fig. 20 is a drawing showing coma in the projection optical system of the ninth example.

Fig. 21 is an example of a flowchart of a technique of fabricating semiconductor devices as micro devices.

## Best Mode for Carrying out the Invention

In the reflective projection optical system of the present invention, light from a first surface (object plane) travels through a first imaging catoptric system G1 to form an intermediate image of the first surface. Then the light from the intermediate image of the first surface formed through the first imaging catoptric system G1 travels through a second imaging catoptric system G2 to form an image of the intermediate image (a reduced image of the first surface) on a second surface (image plane).

The first imaging catoptric system G1 is composed of a first reflecting mirror M1 for reflecting the light from the first surface, a second reflecting mirror M2 for reflecting the light reflected on the first reflecting mirror M1, a third reflecting mirror M3 for reflecting the light reflected on the second reflecting mirror M2, and a fourth reflecting mirror M4 for reflecting the light reflected on the third reflecting mirror M3. The second imaging catoptric system G2 is composed of a fifth reflecting mirror M5 for reflecting the light from the intermediate image, a sixth reflecting mirror M6 for reflecting the light reflected on the fifth reflecting mirror M5, a seventh reflecting mirror M7 for reflecting the light reflected on the sixth reflecting mirror M6, and an eighth reflecting mirror M8 for reflecting the light reflected on the seventh reflecting mirror M7.

Particularly, the reflecting surface of the fourth reflecting mirror M4 or the fifth reflecting mirror M5 is preferably comprised of a spherical surface. The reason is that the fourth reflecting mirror M4 or the fifth reflecting mirror M5 is a partial mirror farthest from the optical axis and is shaped like a part of an annular shape, which used to cause difficulties in every step of polishing, inspection, coating of reflecting film, and assembly. Therefore, when this reflecting surface is comprised of a spherical surface, it becomes very easy to perform such steps as polishing, inspection, and assembly, and it brings about a great cost reduction.

Preferably, among the eight reflecting mirrors, a reflecting surface of a reflecting mirror with a relatively high requirement for manufacturing error is comprised of a spherical surface. For example, the requirement for manufacturing error is severe in a reflecting mirror with a large angle of incidence of a beam to the reflecting mirror and in a reflecting mirror with a small area of a region (effective region) where the beam contributing to imaging is reflected, and it is thus preferable to comprise such a reflecting mirror of a spherical surface. The reason is that the reflecting mirror with the severe requirement for manufacturing error will give rise to relatively large aberration if the shape of the reflecting surface deviates even a little from an ideal designed shape, and that it will result in degradation of final imaging performance. Since the spherical shape can be processed with higher accuracy than the aspherical shape, it is relatively easy to fabricate the high-accuracy projection optical system. Therefore, it becomes feasible to fabricate the projection optical system at low cost and with accuracy.

In the present invention, preferably, a distance d1 between the first surface and the first reflecting mirror M1 satisfies the following condition (1):

$$700 \text{ mm} \leq d1 \qquad (1).$$

If the distance d1 is smaller than the lower limit of Condition (1), angles of incidence of rays to the reflecting surface will be too large to well compensate for emerging aberration.

In the present invention, preferably, a distance d2 from the first reflecting mirror M1 to the second reflecting mirror M2 satisfies the following condition (2):

$$450 \text{ mm} \leq d2 \qquad (2).$$

If the distance d2 is smaller than the lower limit of Condition (2), angles of incidence of rays to the reflecting surface will be too large to well compensate for emerging aberration.

In the present invention, preferably, a distance d3 from the second reflecting mirror M2 to the third reflecting mirror M3 satisfies the following condition (3):

$$570 \text{ mm} \leq d3 \qquad (3).$$

If the distance d3 is smaller than the lower limit of Condition (3), angles of incidence of rays to the reflecting surface will be too large to well compensate for emerging aberration.

When the projection optical system is configured as described above, it can ensure adequate optical performance even if any surface of reflecting mirror is comprised of a spherical surface out of the reflecting mirrors of the first reflecting mirror M1 to the eighth reflecting mirror M8.

An aperture stop AS is preferably located on the second reflecting mirror M2 because interference of beams can be adequately avoided and because it permits reduction in the effective diameters of the reflecting mirrors of the first imaging optical system. In this case, the location of the aperture stop is limited to immediately before the reflecting mirror, and it thus becomes not easy to keep a good balance between upper coma and lower coma.

In such a case, sufficiently long distances are secured for the distance d1 between the first surface and the first reflecting mirror M1, the distance d2 between the first reflecting mirror and the second reflecting mirror M2, and the distance d3 between the second reflecting mirror and the third reflecting mirror M3, whereby angles of incidence of rays to each reflecting mirror can be kept small and rise of aberration is well suppressed to enable good compensation for aberration.

In the present invention, preferably, a ratio of the foregoing distances d1 and d2, d1/d2, satisfies the following condition (4):

$$1 < d1/d2 < 1.9 \qquad (4).$$

If the ratio is off the range of Condition (4), the balance will worsen between upper coma and lower coma so as to make compensation difficult.

In the present invention, preferably, a ratio of the foregoing distances d3 and d2, d3/d2, satisfies the following condition (5):

$$1.1 < d3/d2 < 1.5 \qquad (5).$$

If the ratio is off the range of Condition (5), the balance will worsen between upper coma and lower coma so as to make compensation difficult.

When the projection optical system is configured as described above, it can ensure adequate optical performance even if the sixth reflecting mirror M6 is comprised of a spherical surface.

In the present invention, distortion can be well compensated for by adopting the configuration of forming the reduced image of the first surface on the second surface by twice imaging. It is feasible to keep small angles of reflection of rays from the two reflectors of the first reflecting mirror and the second reflecting mirror and angles of reflection of rays from the reflector outside them, e.g., from the third reflecting mirror.

By adopting the arrangement as described above, it is feasible to reduce the maximum diameter of the reflecting mirrors and to appropriately arrange each reflecting mirror and the aperture stop, without eclipse of beam. Since the angles of incidence of rays to the third reflecting mirror M3 are kept small, it is feasible to keep small the effective diameter of the fourth reflecting mirror M4, which tends to have a large effective diameter.

As described above, the present invention successfully realizes the reflective projection optical system having good reflection characteristics for X-rays as well and permitting good compensation for aberration while suppressing increase in the size of the reflecting mirrors.

In the present invention, preferably, an effective diameter $M\varphi$ of each reflecting mirror M1-M8 satisfies the following condition (6) in each reflecting mirror M1-M8:

$$400 \text{ mm} \le M\varphi \le 600 \text{ mm} \qquad (6).$$

If the effective diameter $M\varphi$ is larger than the upper limit of Condition (6), the effective diameter of the reflecting mirror will be too large and the size of the optical system will become larger, which is not preferred. If it is smaller than the lower limit, the size will be so small as to cause degradation of optical performance, which is not desirable.

Furthermore, when a maximum effective diameter of the reflecting mirrors is defined as $M\varphi$ and when a maximum object height on the object plane is defined as H0, a ratio $M\varphi$/H0 preferably satisfies the following condition (7):

$$2 < M\varphi/H0 < 4 (7).$$

If the ratio is larger than the upper limit of condition (7), the effective diameter of the reflecting mirror will be too large and the size of the optical system will become larger, which is not preferred. If it is smaller than the lower limit, the size will be so small as to cause degradation of optical performance, which is not desirable.

In the present invention, preferably, when an axial distance (object-image distance) between the object (reticle) and the image (wafer) is defined as TT, the axial distance TT satisfies the following condition (8):

$$1350 \text{ mm} < TT < 1800 \text{ mm} \qquad (8).$$

If the distance TT is smaller than the lower limit of Condition (8), it will be easier for the reticle and wafer to mechanically interfere with the reflecting mirrors and the optical performance will also worsen, which is not preferred. If it is over the upper limit, the size of the optical system will increase, which is not preferred, either. The optical system is preferably provided with some length because it can have good optical performance and also keep small angles of incidence of rays to the reflecting mirrors. Since a sufficiently large distance must be secured, particularly, between the reticle and the reflecting mirror closest to it and between the wafer and the reflecting mirror closest to it because of the thickness of a cooling device or the like to be located on the back side of each reflecting mirror, the object-image distance TT has to be set to some length for ensuring it, and thus Condition (8) is preferably to be met.

In the present invention, preferably, when an axial distance (object-image distance) from the object (reticle) to the image (wafer) is defined as TT and when a maximum object height on the object plane is defined as H0, a ratio TT/H0 satisfies the following condition (9):

$$8 < TT/H0 < 15 \qquad (9).$$

If the ratio is smaller than the lower limit of Condition (9), it will be easier for the reticle and wafer to mechanically interfere with the reflecting mirrors and the optical performance will also worsen, which is not preferred. If it is over the upper limit, the size of the optical system will increase, which is not preferred, either. The optical system is preferably provided with some length because it can have good optical performance and also keep small angles of incidence of rays to the reflecting mirrors. Since a sufficiently large distance must be secured, particularly, between the reticle and the reflecting mirror closest to it and between the wafer and the reflecting mirror closest to it because of the thickness of the cooling device or the like to be located on the back side of each reflecting mirror, the object-image distance TT has to be set to some length for ensuring it, and thus Condition (9) is preferably to be met.

In the present invention, in order to achieve good compensation for aberration to improve the optical performance, the reflecting surface of each reflecting mirror is preferably formed in an aspherical shape rotationally symmetric with respect to the optical axis and a maximum order of an aspherical surface defining each reflecting surface is preferably the tenth or higher. In the present invention, the optical system is preferably nearly telecentric on the second surface side. This configuration, for example, when applied to an exposure apparatus, can achieve good imaging even if the wafer is uneven in the depth of focus of the projection optical system.

When the projection optical system of the present invention is applied to an exposure apparatus, X-rays can be used as exposure light. In this case, the mask and the photosensitive substrate are moved relative to the projection optical system to implement projection exposure of the pattern of the mask on the photosensitive substrate. As a result, highly accurate micro devices can be fabricated under a good exposure condition, using the scanning exposure apparatus with a high resolving power.

In the present invention, preferably, another reflective projection optical system has at least eight reflecting mirrors and is adapted to form a reduced image of a first surface on a second surface, and a reflecting mirror with a relatively high requirement for manufacturing error is comprised of a spherical surface. For example, a reflecting mirror with a relatively large angle of incidence of a beam to the reflecting surface or a reflecting mirror with a relatively small area (effective region) where a beam contributing to imaging is reflected on the reflecting surface, is preferably comprised of a spherical surface. The reason is that the reflecting mirror with the severe requirement for manufacturing error will give rise to relatively large aberration if the shape of the reflecting surface deviates even a little from an ideal designed shape, and that it will result in degradation of final imaging performance. Since the spherical shape can be processed with higher accuracy than the aspherical shape, it is relatively easy to fabricate the high-accuracy projection optical system. Therefore, it becomes feasible to fabricate the projection optical system at low cost and with accuracy.

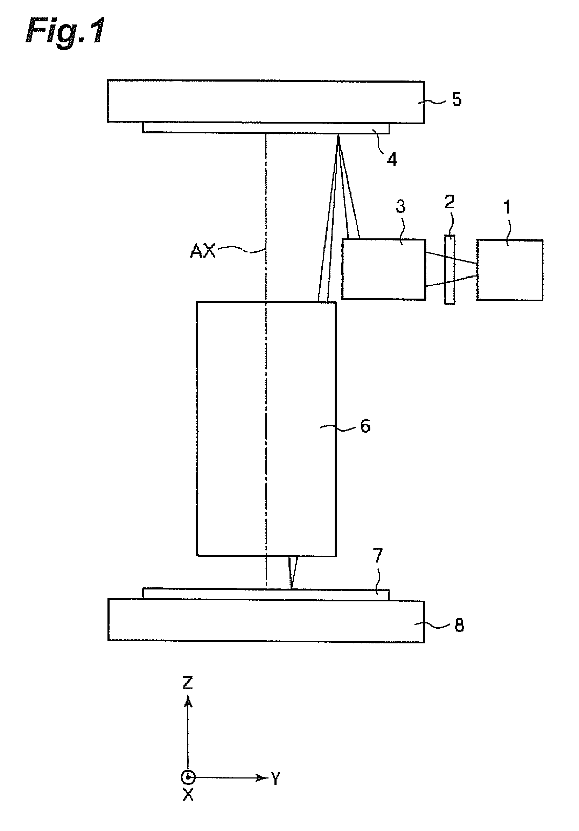

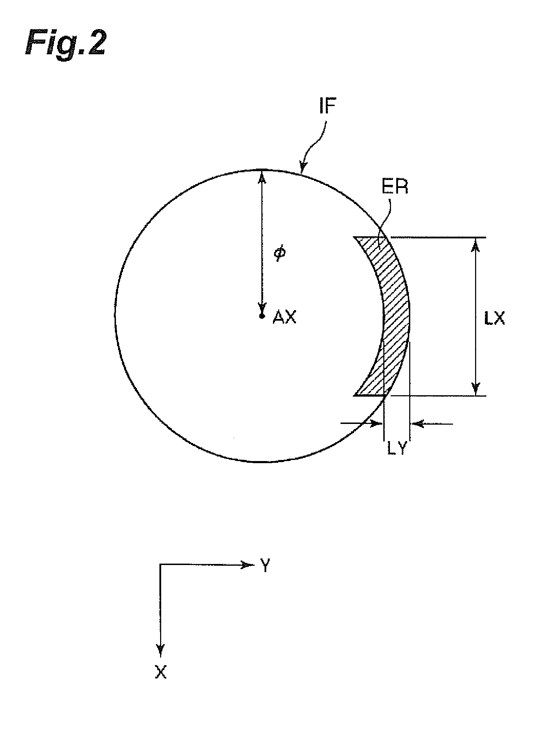

An embodiment of the present invention will be described on the basis of the accompanying drawings. Fig. 1 is a drawing schematically showing a configuration of an exposure apparatus according to the embodiment of the present invention. Fig. 2 is a drawing showing a positional relation between an arcuate exposure region (or effective imaging region) formed on a wafer, and the optical axis. In Fig. 1, the Z-axis is set along the direction of the optical axis of the projection optical system, i.e., a direction of a normal to the wafer W being a photosensitive substrate, the Y-axis along a direction parallel to the plane of Fig. 1 in the plane of the wafer, and the X-axis along the direction perpendicular to the plane of Fig. 1 in the plane of the wafer.

The exposure apparatus of Fig. 1 is provided, for example, with a laser plasma X-ray source 1 as a light source for supplying exposure light. Light emitted from the X-ray source 1 travels through a wavelength-selective filter 2 to enter an illumination optical system 3. The wavelength-selective filter 2 has such a characteristic as to selectively transmit only X-rays of a predetermined wavelength (13.5 nm) out of the light supplied from the X-ray source and block light of the other wavelengths.

X-rays having passed through the wavelength-selective filter 2 travel via the illumination optical system 3 composed of a plurality of reflecting mirrors, to illuminate a reflective mask 4 in which a pattern to be transferred is formed. The mask 4 is held by a mask stage 5 movable along the Y-direction, so that its pattern surface extends along the XY plane. Movement of the mask stage 5 is measured by an undepicted laser interferometer. In this way, an arcuate illumination region symmetric with respect to the Y-axis is formed on the mask 4.

Light from the mask 4 thus illuminated travels via a reflective projection optical system 6 to form an image of the mask pattern on a wafer 7 being a photosensitive substrate. Namely, an arcuate exposure region symmetric with respect to the Y-axis is formed on the wafer 7, as shown in Fig. 2. With reference to Fig. 2, the arcuate effective exposure region (effective imaging region) ER with the X-directional length LX and the Y-directional length LY is set in a circular region (image circle) IF with radius $\varphi$ centered on the optical axis AX, so as to abut on the image circle IF.

The wafer 7 is held by a wafer stage 8 two-dimensionally movable along the X-direction and along the Y-direction, so that an exposed surface thereof extends along the XY plane. Movement of the wafer stage 8 is measured by an undepicted laser interferometer, as in the case of the mask stage 5. While the mask stage 5 and the wafer stage 8 are moved along the Y-direction as described above, i.e., while the mask 4 and the wafer 7 are moved along the Y-direction relative to the projection optical system 6, scan exposure (scanning exposure) is effected to transfer the pattern of the mask 4 into one exposure region on the wafer 7.

At this time, where the projection magnification (transfer magnification) of the projection optical system 6 is 1/4, synchronous scanning is performed in such a setting that a moving speed of the wafer stage 8 is 1/4 of a moving speed of the mask stage 5. As scanning exposure is repeated with two-dimensional movement of the wafer stage 8 along the X-direction and along the Y-direction, the pattern of the mask 4 is sequentially transferred into each of exposure regions on the wafer 7. Specific configurations of the projection optical system 6 will be described below with reference to the first to ninth examples.

In each example, the projection optical system 6 is composed of a first imaging catoptric system G1 for forming an intermediate image of the pattern of the mask 4, and a second imaging catoptric system G2 for forming an image of the intermediate image of the mask pattern (secondary image of the pattern of the mask 4) on the wafer 7. The first imaging catoptric system G1 is composed of four reflecting mirrors M1-M4 and the second imaging catoptric system G2 is composed of four reflecting mirrors M5-M8.

In each example, at least one reflecting surface among the eight reflecting mirrors is formed in a spherical shape. In each example, an aperture stop is located immediately before the second reflecting mirror M2. The aperture stop AS may be arranged in contact with the reflecting mirror M2 or near it. Furthermore, in each example, the projection optical system 6 is an optical system telecentric on the wafer side (image side).

In each example, the third reflecting mirror M3 is located as directed toward the first reflecting mirror M1 in the image-side space, but, without being limited to it, similar action can also be achieved when the third reflecting mirror M3 is located as directed toward the first reflecting mirror M1 in the object-side space.

In each example, each aspherical surface is expressed by Formula (b) below where y represents a height in the direction perpendicular to the optical axis, z a distance (sag) along the optical axis from a tangent plane at a vertex of the aspherical surface to a position on the aspherical surface at the height y, r a radius of curvature at the vertex, K the conical coefficient, and A, B, C, D,... aspherical coefficients of fourth order, sixth order, eighth order, tenth order,..., respectively.

$$z = (y^2/r)/\{1+\{1-(1+\kappa)\cdot y^2/r^2\}^{1/2}\}$$
$$+A\cdot y^4+B\cdot y^6+C\cdot y^8+D\cdot y^{10}+\dots \qquad (b)$$

[Example 1]

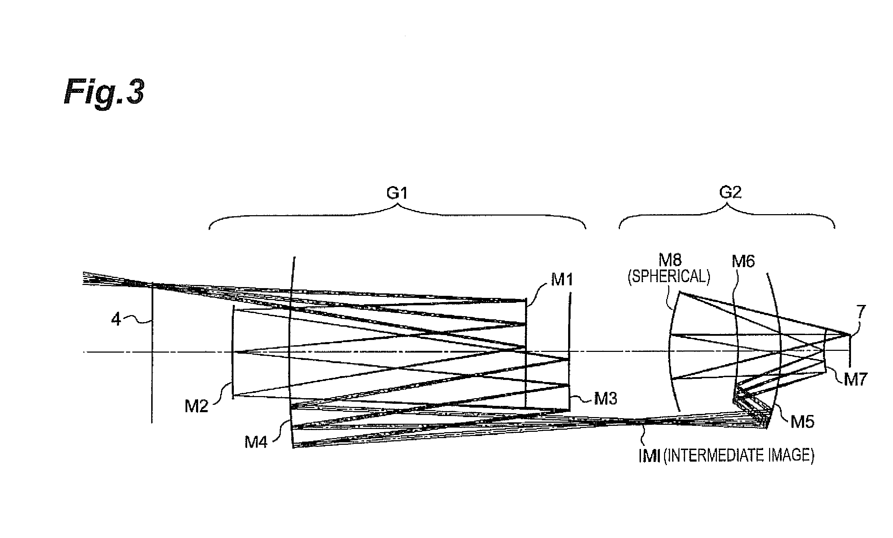

Fig. 3 is a drawing showing a configuration of the projection optical system according to the first example of the present embodiment. With reference to Fig. 3, the projection optical system of the first example is configured as follows: light from the mask 4 is successively reflected on a convex reflecting surface of the first reflecting mirror M1, on a concave reflecting surface of the second reflecting mirror M2, on a convex reflecting surface of the third reflecting mirror M3, and on a concave reflecting surface of the fourth reflecting mirror M4 to form an intermediate image of the mask pattern. Then the light from the intermediate image of the mask pattern formed via the first imaging catoptric system G1 is successively reflected on a concave reflecting surface of the fifth reflecting mirror M5, on a convex reflecting surface of the sixth reflecting mirror, on a convex reflecting surface of the seventh reflecting mirror, and on a concave reflecting surface of the eighth reflecting mirror M8 to form a reduced image (secondary image) of the mask pattern on the wafer 7. In the projection optical system of the first example the concave eighth reflecting mirror M8 is comprised of a spherical surface.

Table (1) below presents values of specifications of the projection optical system according to the first example. In Table (1), λ represents the wavelength of exposure light, β the projection magnification, NA the numerical aperture, H0 the maximum object height on the mask 4, φ the radius (maximum image height) of the image circle IF on the wafer 7, LX the length along the X-direction of the effective exposure region ER, and LY the length along the Y-direction of the effective exposure region ER. Furthermore, Mφ represents the effective diameter of the largest reflecting mirror and TT the axial distance between the mask 4 and the wafer 7.

The surface number indicates an order of each reflecting surface from the mask side along the traveling direction of rays from the mask surface as the object plane to the wafer surface as the image plane, r a radius of curvature at a vertex of each reflecting surface (mm), and d an axial distance or surface separation of each reflecting surface (mm). The surface separation d is assumed to change its sign every reflection. Furthermore, d1 is defined as the distance from the mask surface to the first reflecting mirror M1, d2 as the distance from the first reflecting mirror to the second reflecting mirror, and d3 as the distance from the second reflecting mirror to the third reflecting mirror. The radius of curvature of a convex surface toward the mask side is defined as positive and the radius of curvature of a concave surface toward the mask side, as negative, irrespective of the direction of incidence of rays. The foregoing notation will also apply similarly to Table (2) to Table (9) hereinafter.

Table (1)

(Principal Specification)

λ = 13.5 nm
β = ¼
NA=0.25
H0 = 156 mm
φ=40mm
LX=26mm
LY=2mm

(Specification of Optical members)

| Surface Number | r | d | Optical Member |
|---|---|---|---|
| S0 | (mask surface) | 853.78 | |
| S1 | 19905.36 | -674.34 | (1st reflecting mirror M1) |
| S2 | 1641.16 | 774.34 | (2nd reflecting mirror M2) |
| S3 | 2714.26 | -643.96 | (3rd reflecting mirror M3) |
| S4 | 2000.00 | 1132.02 | (4th reflecting mirror M4) |
| S5 | -516.16 | -100.00 | (5th reflecting mirror M5) |
| S6 | -669.72 | 200.10 | (6th reflecting mirror M6) |
| S7 | 296.26 | -354.43 | (7th reflecting mirror M7) |

(continued)

(Specification of Optical members)

| Surface Number | r | d | Optical Member |
|---|---|---|---|
| S8 | 440.87 | 412.49 | (8th reflecting mirror M8) spherical |

(wafer surface) (Aspherical Data)

S1 Surface

$\kappa = 0.00$

A = 8.96915E-12 B = 4.57005E-15 C =-1.83735E-19 D= 8.60247E-24 E =-3.56869E-28 F = 1.00209E-32 G =-1.20203E-37 H = 0.00000E+00

S2 Surface

$\kappa$ = 0.00A = 3.18467E-12B = 3.26352E-16C = 3.38845E-21D =-2.12437E-25E = 2.30692E-29F =-1.32519E-33G = 3.17447E-38H = 0.00000E+00

S3 Surface

$\kappa$ = 0.00: A =-9.07468E-10: B = 1.43591E-15: C = 8.76013E-21: D =-3.72599E-25: E = 2.07244E-29: F =-6.63254E-34: G = 8.79762E-39: H = 0.00000E+00

S4 Surface

$\kappa$ = 0.00: A =-2.13729E-10: B =-8.32168E-16: C = 1.22199E-20: D =-3.29219E-25: E = 4.90034E-30: F =-4.07991E-35: G = 1.47092E-40: H = 0.00000E+00

S5 Surface

$\kappa$ = 0.00: A = 2.51736E-10: B =-2.83431E-14: C = 2.53784E-18: D =-1.25361E-22: E = 3.60082E-27: F =-5.65216E-32: G = 3.76339E-37: H = 0.00000E+00

S6 Surface

$\kappa$ = 0.00: A = 8.73334E-11: B = 1.51075E-14: C =-1.38072E-18: D = 1.13509E-22: E =-5.02784E-27: F = 5.30624E-32: G=2.27212E-36: H = 0.00000E+00

S7 Surface

$\kappa$ = 0.00: A = 1.11175E-08: B =-8.63766E-14: C = 1.14445E-16: D =-3.307015E--20: E = 1.08345E-23: F =-2.19060E-27: G = 1.81307E-31: H = 0.00000E+00 S8 Surface Spherical Surface (Values Corresponding to Conditions)

M$\varphi$ = 435.34 mm (maximum at the fourth reflecting mirror M4) TT = 1600.0 mm

M$\varphi$/H0 = 2.79

TT/H0 = 10.26 d1 = 853.78 mm d2 = 674.34 mm d3 = 774.34 mm d1/d2 = 1.27 d3/d2=1.15

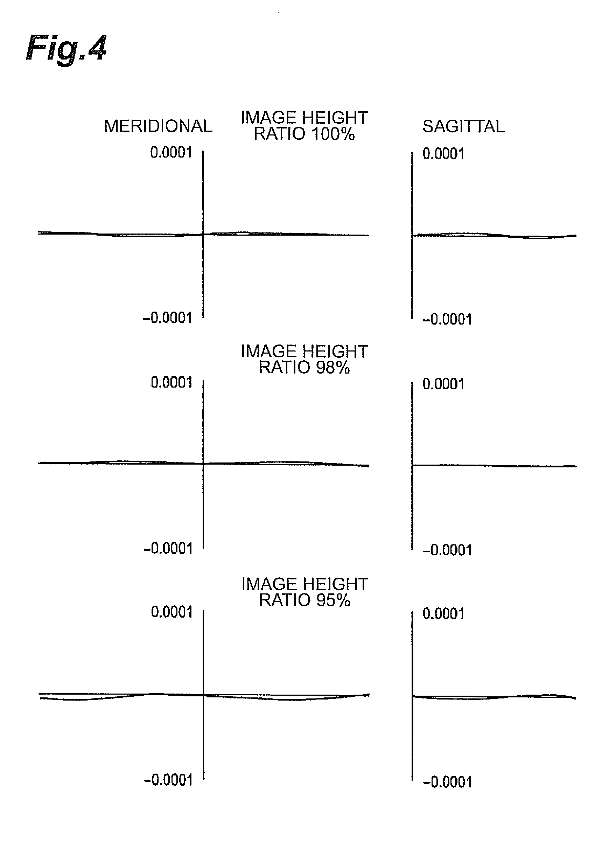

Fig. 4 is a drawing showing coma in the projection optical system of the first example. Fig. 4 shows the meridional coma and sagittal coma at the image height 100%, at the image height 98%, and at the image height 95%. It is apparent from the aberration diagram that in the first example, coma is well compensated for in the region corresponding to the effective imaging region ER. It was confirmed, though not depicted, that the aberrations other than coma, e.g., spherical aberration and distortion, were also well compensated for in the region corresponding to the effective imaging region ER.

[Example 2]

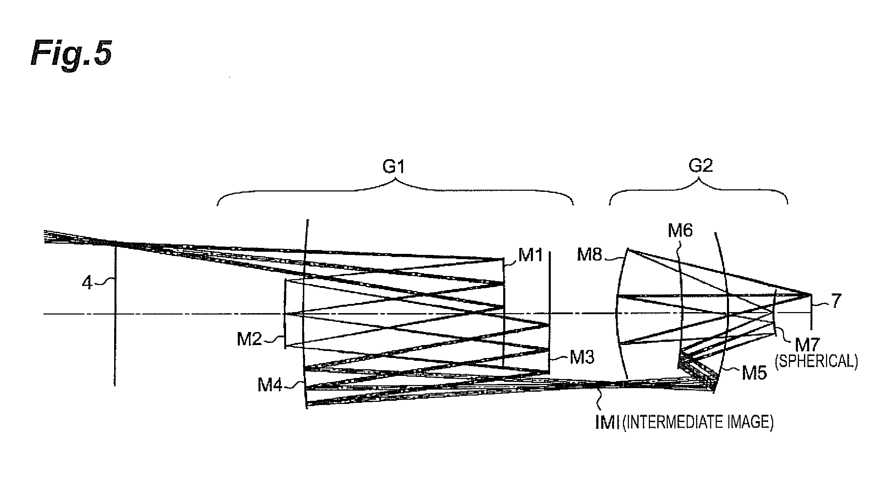

Fig. 5 is a drawing showing a configuration of the projection optical system according to the second example of the present embodiment. With reference to Fig. 5, the projection optical system of the second example is configured as follows: light from the mask 4 is successively reflected on a concave reflecting surface of the first reflecting mirror M1, on a concave reflecting surface of the second reflecting mirror M2, on a convex reflecting surface of the third reflecting mirror M3, and on a concave reflecting surface of the fourth reflecting mirror M4 to form an intermediate image of the mask pattern. Then the light from the intermediate image of the mask pattern formed via the first imaging catoptric system G1 is successively reflected on a concave reflecting surface of the fifth reflecting mirror M5, on a convex reflecting surface of the sixth reflecting mirror, on a convex reflecting surface of the seventh reflecting mirror, and on a concave reflecting surface of the eighth reflecting mirror M8 to form a reduced image (secondary image) of the mask pattern on the wafer 7. In the projection optical system of the first example the eighth reflecting mirror M8 was comprised of a spherical surface, whereas in the present example the convex seventh reflecting mirror is comprised of a spherical surface. Table (2) below presents values of specifications of the projection optical system according to the second example.

Table (2)

(Principal Specification)

$\lambda$ = 13.5 nm
$\beta$ = ¼
NA = 0.25
H0 = 156 mm
$\varphi$ = 40 mm
LX = 26 mm
LY = 2 mm

(Specifications of Optical Member)

| Surface Number | r | d | Optical Member |
|---|---|---|---|
| S0(mask surface) | | 853.38 | |
| S1 | -4000.53 | -482.41 | (1st reflecting mirror M1) |
| S2 | 2026.25 | 582.41 | (2nd reflecting mirror M2) |
| S3 | 6778.35 | -542.84 | (3rd reflecting mirror M3) |
| S4 | 1879.97 | 938.17 | (4th reflecting mirror M4) |
| S5 | -549.39 | -100.00 | (5th reflecting mirror M5) |
| S6 | -900.99 | 200.00 | (6th reflecting mirror M6) |
| S7 | 245.23 | -345.33 | (7th reflective mirror M7) spherical |

(continued)

(Specifications of Optical Member)

| Surface Number | r | d | Optical Member |
|---|---|---|---|
| S8 | 438.06 | 427.54 | (8th reflecting mirror M8) |

(wafer surface) (Aspherical Data)

S1 Surface

$\kappa = 0.00$:

A = 4.12013E-10: B = 6.16521E-16: C =-2.33472E-20: D = 7.81561E-25: E =-5.08210E-29: F = 1.95820E-33: G =-3.29132E-38: H = 0.00000E+00

S2 Surface

$\kappa = 0.00$:

A =-7.17094E-11: B =-2.37267E-15: C =-9.23185E-20: D = 2.71631E-23: E =-5.80866E-27: F = 6.58718E-31: G =-3.07733E-35: H = 0.00000E+00

S3 Surface

$\kappa = 0.00$:

A =-9.08546E-10: B = 1.93599E-15: C = 1.54171E-21: D =-1.14433E-24: E = 7.25350E-29: F =-2.27698E-33: G = 2.87734: E-38: H = 0.00000E+00

S4 Surface

$\kappa = 0.00$:

A =-3.26333E-10: B =-1.31852E-15: C = 2.17785E-20: D =-6.99551E-25: E = 1.20401E-29: F =-1.15499E-34: G = 4.70578E-40: H = 0,00000E+00

S5 Surface

$\kappa = 0.00$:

A =-4.06078E-10: B =-2.02518E-14: C = 2.35353E-18: D=-1.18310E-22: E = 3.19720E-27: F =-4.55065E-32: G = 2.69146E-37: H = 0.00000E+00

S6 Surface

$\kappa = 0.00$:

A =-2.15942E-09: B = 1.02618E-13: C =-7.03971 E-18: D = 2.64439E-22: E = 1.05365E-27: F =-3.98918E-31: G = 9.07261E-36: H = 0.00000E+00 S7 Surface Spherical

S8 Surface

$\kappa = 0.00$: A = 4.10687E-11: B = 4.53532E-16: C = 2.41040E-21: D = 3.89228E-26: E =-1.67001E-31: F =-1.19286E-35: G = 3.37603E-40: H = 0.00000E+00 (Values Corresponding to Conditions):

M$\varphi$ = 404.78 (maximum at fourth reflecting mirror M4)

TT= 1530.9

M$\varphi$/H0 =2.59

TT/H0=9.81 d1=853.38 mm d2 = 482.41 mm d3 = 582.41 mm d1/d2 = 1.77d3/d2 = 1.21

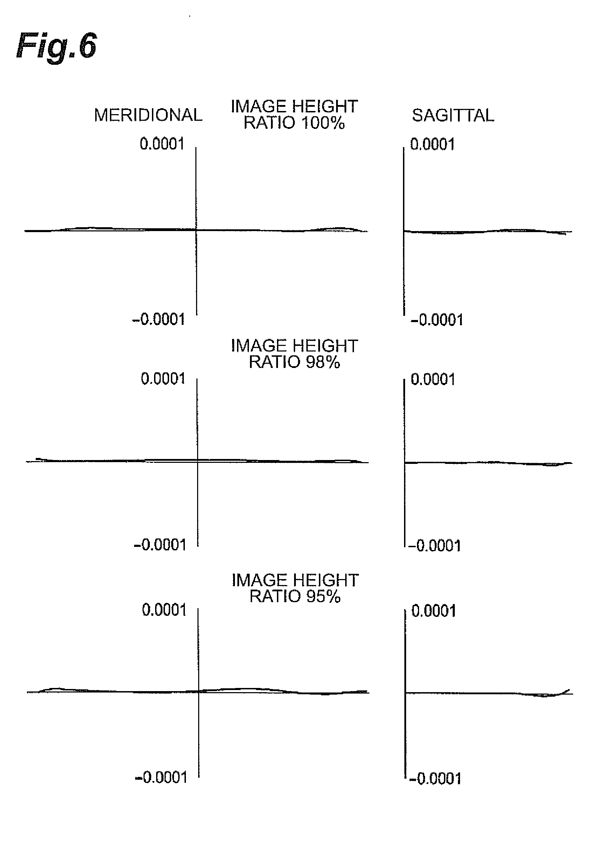

Fig. 6 is a drawing showing coma in the projection optical system of the second example. Fig. 6 shows the meridional coma and sagittal coma at the image height 100%, at the image height 98%, and at the image height 95%. It is apparent from the aberration diagram that in the second example, coma is well compensated for in the region corresponding to the effective imaging region ER. It was confirmed, though not depicted, that the aberrations other than coma, e.g., spherical aberration and distortion, were also well compensated for in the region corresponding to the effective imaging region ER.

[Example 3]

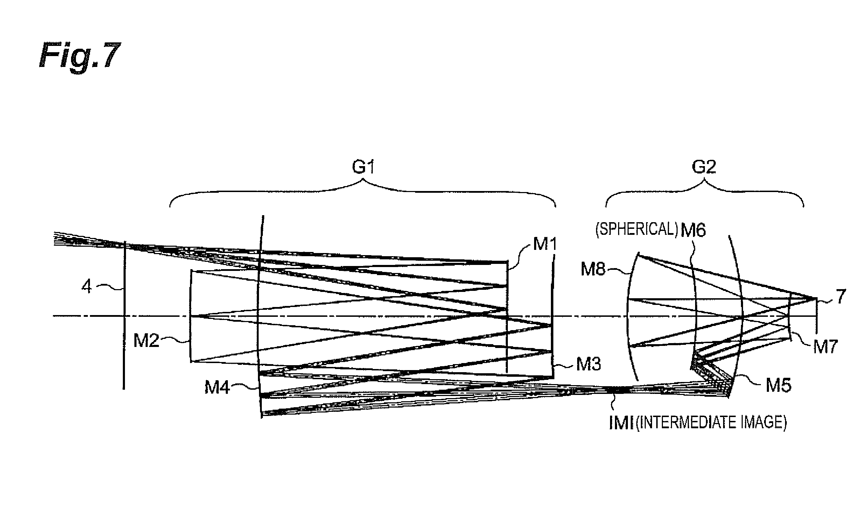

Fig. 7 is a drawing showing a configuration of the projection optical system according to the third example of the present embodiment. With reference to Fig. 7, the projection optical system of the third example is configured as follows: light from the mask 4 is successively reflected on a convex reflecting surface of the first reflecting mirror M1, on a concave reflecting surface of the second reflecting mirror M2, on a convex reflecting surface of the third reflecting mirror M3, and on a concave reflecting surface of the fourth reflecting mirror M4 to form an intermediate image of the mask pattern. Then the light from the intermediate image of the mask pattern formed via the first imaging catoptric system G1 is successively reflected on a concave reflecting surface of the fifth reflecting mirror M5, on a convex reflecting surface of the sixth reflecting mirror, on a convex reflecting surface of the seventh reflecting mirror, and on a concave reflecting surface of the eighth reflecting mirror M8 to form a reduced image (secondary image) of the mask pattern on the wafer 7. In the projection optical system of the first example the eighth reflecting mirror was comprised of a spherical surface, whereas in the present example the convex sixth reflecting mirror is comprised of a spherical surface. Table (3) below presents values of specifications of the projection optical system according to the third example.

Table (3)

(Principal Specifications)

$\lambda$ = 13.5 nm

$\beta$ = ¼

NA=0.25

H0=156 mm

$\varphi$ =40 mm

LX=26mm

LY=2mm

(Specifications of Optical Members)

| Surface Number | r | d | Optical Member |
|---|---|---|---|
| S0 (mask surface) | | 836.47 | |
| S1 | 16673.90 | -695.19 | (first reflective mirror M1) |
| S2 | 1639.24 | 795.19 | (second reflective mirror M2) |
| S3 | 2815.49 | -648.41 | (third reflective mirror M3) |
| S4 | 2000.00 | 1066.92 | (4th reflecting mirror M4) |
| S5 | -512.93 | -100.00 | (5th reflecting mirror M5) |
| S6 | -643.25 | 200.03 | (6th reflecting mirror M6) spherical |
| S7 | 301.55 | -353.85 | (7th reflecting mirror M7) |

(continued)

(Specifications of Optical Members)

| Surface Number | r | d | Optical Member |
|---|---|---|---|
| S8 | 441.40 | 414.82 | (8th reflecting mirror M8) |

(wafer surface) (Aspherical Data)

S1 Surface

$\kappa = 0.00$

A = 4.14433E-12: B=3.61576E-15: C =-7.71811E-20: D= 2.64652E-24: E =-1.43402E-28: F = 5.56988E-33: G =-9.41512E-38: H = 0.00000E+00

S2 Surface

$\kappa = 0.00$

A =-2.84150E-11: B = 3.70117E-17: C = 4.22879E-22: D =-5.02449E-26: E=3.31104E-30: F=-8.90095E-35: G=-1.76692E-40: H= 0.00000E+00

S3 Surface

$\kappa = 0.00$

A =-7.82732E-10: B = 9.89079E-16: C =-7.23616E-21: D = 8.03932E-25: E=-3.45519E-29: F=8.18704E-34: G=-8.32530E-39: H= 0.00000E+00

S4 Surface

$\kappa = 0.00$

A=-2.25046E-10:   B  =-7.19387E-16:   C=8.48834E-21:   D=-2.83313E-25: E=4.73790E-30: F=-4.38195E-35: G=1.73302E-40: H= 0.00000E+00

S5 Surface

$\kappa = 0.00$

A = 1.80833E-10: B =-2.77427E-14: C = 2.58714E-18: D =-1.25119E-22: E = 3.41819E-27: F =-5.03030E-32: G = 3.11125E-37: H = 0.0000E+00 S6 Surface Spherical

S7 Surface

$\kappa = 0.00$

A= 1.04479E-08: B =-4.88154E-14: C = 3.76442E-17: D =-8.28206E-21: E=4.32265E-24: F=-1.17557E-27: G=1.26940E-31: H=0.00000E+00

S8 Surface

$\kappa = 0.00$:

A = 3.98331E-11: B = 2.83203E-16: C = 1.97232E-21: D =-1.55350E-26: E=1.96749E-30: F =-6.13747E-35: G=7.82354E-40: H= 0.00000E+00 (Values Corresponding to Conditions)

M$\varphi$ = 435.74 (maximum at the fourth reflecting mirror M4)

TT= 1516.0

M$\varphi$/H0 = 2.79

TT/H0 = 9.72 d1 = 836.47 mm d2 = 695.19 mm d3 = 795.19 mm d1/d2 = 1.20 d3/d2 = 1.14

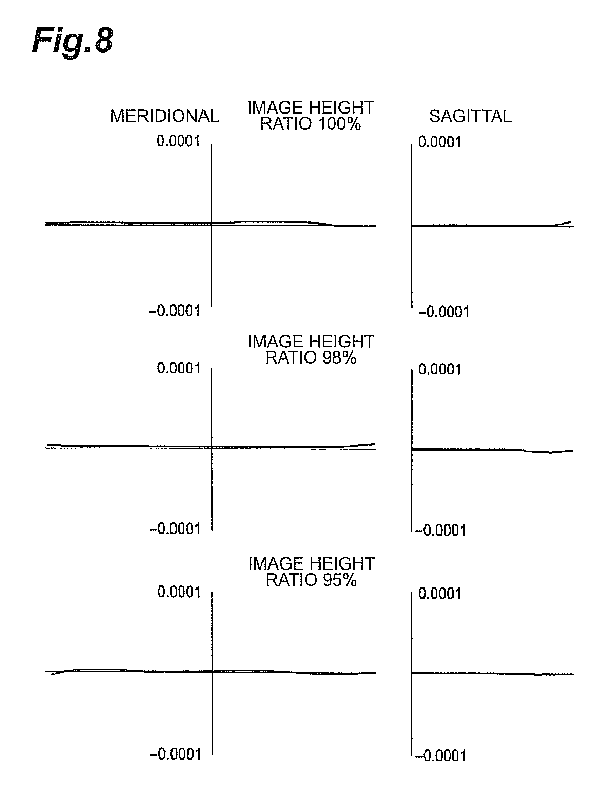

Fig. 8 is a drawing showing coma in the projection optical system of the second example. Fig. 8 shows the meridional coma and sagittal coma at the image height 100%, at the image height 98%, and at the image height 95%. It is apparent from the aberration diagram that in the third example, coma is well compensated for in the region corresponding to the effective imaging region ER. It was confirmed, though not depicted, that the aberrations other than coma, e.g., spherical aberration and distortion, were also well compensated for in the region corresponding to the effective imaging region ER.

[Example 4]

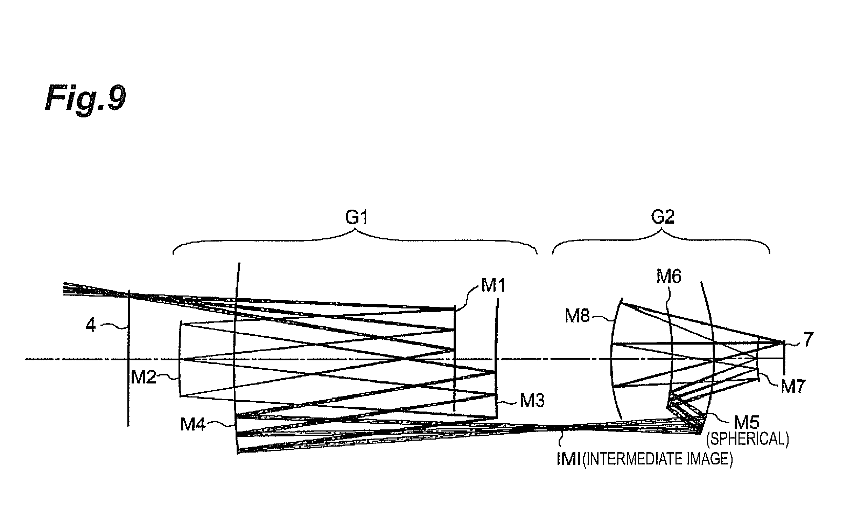

Fig. 9 is a drawing showing a configuration of the projection optical system according to the fourth example of the present embodiment. With reference to Fig. 9, the projection optical system of the fourth example is configured as follows: light from the mask 4 is successively reflected on a concave reflecting surface of the first reflecting mirror M1, on a concave reflecting surface of the second reflecting mirror M2, on a convex reflecting surface of the third reflecting mirror M3, and on a concave reflecting surface of the fourth reflecting mirror M4 to form an intermediate image of the mask pattern. Then the light from the intermediate image of the mask pattern formed via the first imaging catoptric system G1 is successively reflected on a concave reflecting surface of the fifth reflecting mirror M5, on a convex reflecting surface of the sixth reflecting mirror, on a convex reflecting surface of the seventh reflecting mirror, and on a concave reflecting surface of the eighth reflecting mirror M8 to form a reduced image (secondary image) of the mask pattern on the wafer 7. In the projection optical system of the first example the eighth reflecting mirror was comprised of a spherical surface, whereas in the present example the concave fifth reflecting mirror is comprised of a spherical surface. Table (4) below presents values of specifications of the projection optical system according to the fourth example.

Table (4)

(Principal Specifications)

$\lambda$ = 13.5 nm
$\beta$ = ¼
NA=0.25
H0=156mm
$\varphi$=40mm
LX=26 mm
LY=2mm

(Specifications of Optical Members)

| Surface Number | r | d | Optical Member |
|---|---|---|---|
| S0(mask | surface) | 781.95 | |
| S1 | -28805.85 | -661.95 | (1st reflecting mirror M1) |
| S2 | 1743.86 | 761.95 | (2nd reflecting mirror M2) |
| S3 | 3637.96 | -631.50 | (3rd reflecting mirror M3) |
| S4 | 2000.00 | 1158.09 | (4th reflecting mirror M4) |
| S5 | -515.87 | -100.00 | (5th reflecting mirror M5) spherical |
| S6 | -647.38 | 203.27 | (6th reflecting mirror M6) |
| S7 | 287.98 | -350.33 | (7th reflecting mirror M7) |

(continued)

(Specifications of Optical Members)

| Surface Number | r | d | Optical Member |
|---|---|---|---|
| S8 | 440.27 | 414.51 | (8th reflecting mirror M8) |

(wafer surface) (Aspherical Data)

S1 Surface

$\kappa = 0.00$

A =-1.01007E-10: B = 3.95362E-15: C =-7.20224E-20: D = 1.60201E-24: E =-4.75389E-29: F = 7.32205E-34: G = 2.71057E-39: H = 0.00000E+00

S2 Surface

$\kappa = 0.00$

A =-5.33007E-11: B = 3.44289E-16: C = 7.65850E-21: D =-7.52411E-25: E=1.09544E-28: F=-7.97740E-33: G=2.37891E-37: H= 0.00000E+00

S3 Surface

$\kappa = 0.00$

A =-7.60928E-10: B=4.95409E-16: C=-3.84238E-21: D=4.64869E-25: E =-1.44100E-29: F= 2.13256E-34: G=-9.00528E-40: H= 0.00000E+00

S4 Surface

$\kappa = 0.00$

A =2.06765E-10: B=-8.80308E-16: C=1.56045E-20: D=-4.41065E-25: E=6.77042E-30: F=-5.78228E-35: G=2.11007E-40: H= 0.00000E+00 S5 Surface Spherical

S6 Surface

$\kappa = 0.00$

A =-7.19381E-10: B =-1.88098E-14: C=3.70991E-18: D=-3.29939E-22: E=1.82185E-26: F=-5.71942E-31: G=7.75005E-36: H= 0.00000E+00

S7 Surface

$\kappa = 0.00$

A = 1.06857E-08: B=1.17184E-13: C=3.48324E-17: D=-4.32361E-21: E=1.73807E-24: F =-2.77947E-28: G= 1.07444E-32: H= 0.00000E+00

S8 Surface

$\kappa = 0.00:$

A= 4.94751E-11: B= 2.43983E-16: C=8.33827E-22: D = 1.62044E-26: E=-5.45757E-31: F=1.27492E-35: G =-1. 18273E-40: H = 0.00000E+00 (Values Corresponding to Conditions)

M$\phi$ = 448.34 (maximum at the fourth reflecting mirror M4)

TT = 1576.0

M$\phi$/H0 = 2.87

TT/H0 = 10.10 d1 = 781.95 mm d2 = 661.95 mm d3 = 761.95 mm d1/d2 = 1.18 d3/d2 = 1.15

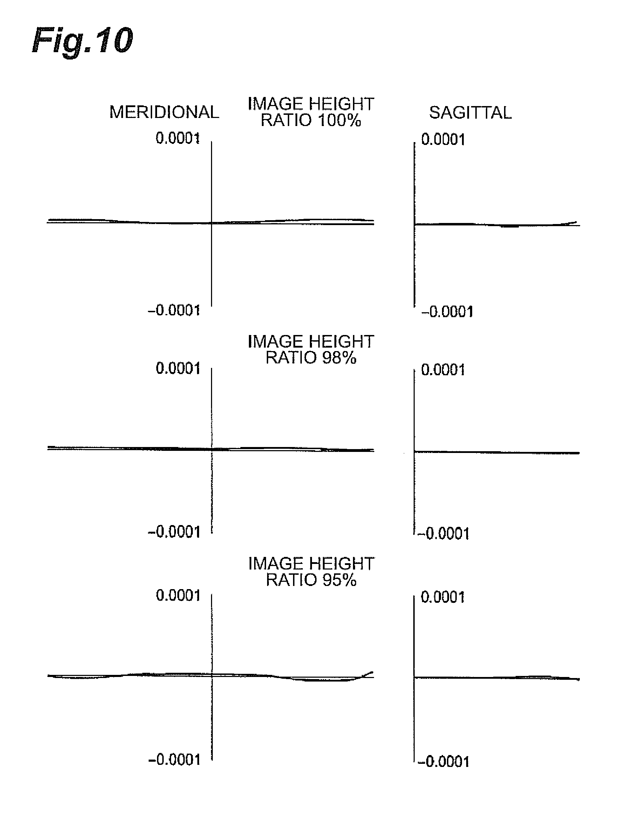

Fig. 10 is a drawing showing coma in the projection optical system of the fourth example. Fig. 10 shows the meridional coma and sagittal coma at the image height 100%, at the image height 98%, and at the image height 95%. It is apparent from the aberration diagram that in the fourth example, coma is well compensated for in the region corresponding to the effective imaging region ER. It was confirmed, though not depicted, that the aberrations other than coma, e.g., spherical aberration and distortion, were also well compensated for in the region corresponding to the effective imaging region ER.

[Example 5]

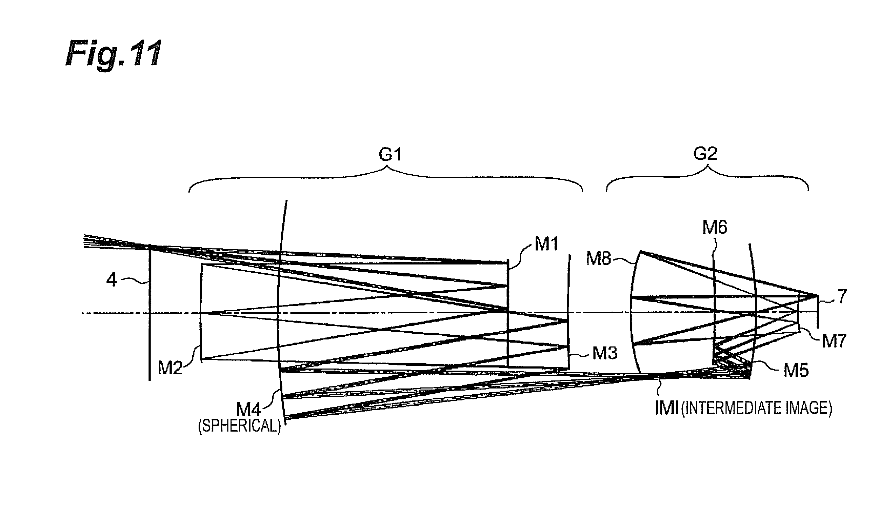

Fig. 11 is a drawing showing a configuration of the projection optical system according to the fifth example of the present embodiment. With reference to Fig. 11, the projection optical system of the fifth example is configured as follows: light from the mask 4 is successively reflected on a convex reflecting surface of the first reflecting mirror M1, on a concave reflecting surface of the second reflecting mirror M2, on a convex reflecting surface of the third reflecting mirror M3, and on a concave reflecting surface of the fourth reflecting mirror M4 to form an intermediate image of the mask pattern. Then the light from the intermediate image of the mask pattern formed via the first imaging catoptric system G1 is successively reflected on a concave reflecting surface of the fifth reflecting mirror M5, on a convex reflecting surface of the sixth reflecting mirror, on a convex reflecting surface of the seventh reflecting mirror, and on a concave reflecting surface of the eighth reflecting mirror M8 to form a reduced image (secondary image) of the mask pattern on the wafer 7. In the projection optical system of the first example the eighth reflecting mirror was comprised of a spherical surface, whereas in the present example the concave fourth reflecting mirror is comprised of a spherical surface. Table (5) below presents values of specifications of the projection optical system according to the fifth example.

Table (5)

(Principal Specifications)

$\lambda$ = 13.5 nm
$\beta$ = ¼
NA = 0.25
H0 = 156mm
$\varphi$ = 40mm
LX=26 mm
LY=2mm

(Specifications of Optical Members)

| Surface Number | r | d | Optical Member |
|---|---|---|---|
| S0(mask surface) | | 855.76 | |
| S1 | 8877.90 | -735.75 | (1st reflecting mirror M1) |
| S2 | 1582.90 | 879.63 | (2nd reflecting mirror M2) |
| S3 | 1755.49 | -698.06 | (3rd reflecting mirror M3) |
| S4 | 1761.63 | 1150.58 | (4th reflecting mirror M4) spherical |
| S5 | -759.00 | -100.00 | (5th reflecting mirror M5) |
| S6 | -2512.82 | 200.00 | (6th reflecting mirror M6) |
| S7 | 271.11 | -302.52 | (7th reflecting mirror M7) |

(continued)

(Specifications of Optical Members)

| Surface Number | r | d | Optical Member |
|---|---|---|---|
| S8 | 482.40 | 450.37 | (8th reflecting mirror M8) |

(wafer surface) (Aspherical Data)

S1 Surface

$\kappa = 0.00$

A=4.86388E-10: B=3.69294E-14: C=-2.40380E-18: D=1.52251E-22: E=-7.12313E-27: F=2.04697E-31: G=-2.69984E-36: H= 0.00000E+00

S2 Surface

$\kappa = 0.00$:

A = 5.50594E-11: B =-2.04768E-16: C = 3.01118E-20: D =-4.15366E-24: E=3.30674E-28: F=-1.42210E-32: G=2.54409E-37: H= 0.00000E+00

S3 Surface

$\kappa = 0.00$:

A =3.18748E-11: B =-3.58792E-17: C =-7.44055E-20: D =5.26232E-24: E=-2.36267E-28: F=5.62019E-33: G=-5.28182E-38: H= 0.00000E+00 S4 Surface Spherical

S5 Surface

$\kappa = 0.00$

A = 8.68542E-10: B =-7.07164E-14: C = 2.77451E-18: D=-1.09193E-22: E=6.12882E-27: F=-1.98877E-31: G=2.47385E-36: H= 0.00000E+00

S6 Surface

$\kappa = 0.00$

A= 1.43537E-09: B =-1.82807E-13: C = 2.25287E-17: D =-7.06178E-22: E=-2.55617E-26: F=2.50370E-30: G=-5.05416E-35: H= 0.00000E+00

S7 Surface

$\kappa = 0.00$

A = 1.50565E-08: B =-3.37130E-12: C = 1.35006E-15: D =-5.19281E-19: E = 1.51018E-22; F =-2.69433E-26: G = 2.17856E-30: H = 0.00000E+00

S8 Surface

$\kappa = 0.00$

A = 3.82947E-11: B = 2.26337E-16: C = 5.47822E-21: D =-3.00184E-25: E=1.26429E-29: F=-2.74528E-34: G=2.55201E-39: H= 0.00000E+00 (Values Corresponding to Conditions)

M$\varphi$ = 517.35 (maximum at the fourth reflecting mirror M4)

TT = 1600.0

M$\varphi$/H0 = 3.32

TT/H0 = 10.26 d1 = 855.76 mm d2 = 735.75 mmd3 = 879.63 mm d1/d2 = 1.16 d3/d2=1.20

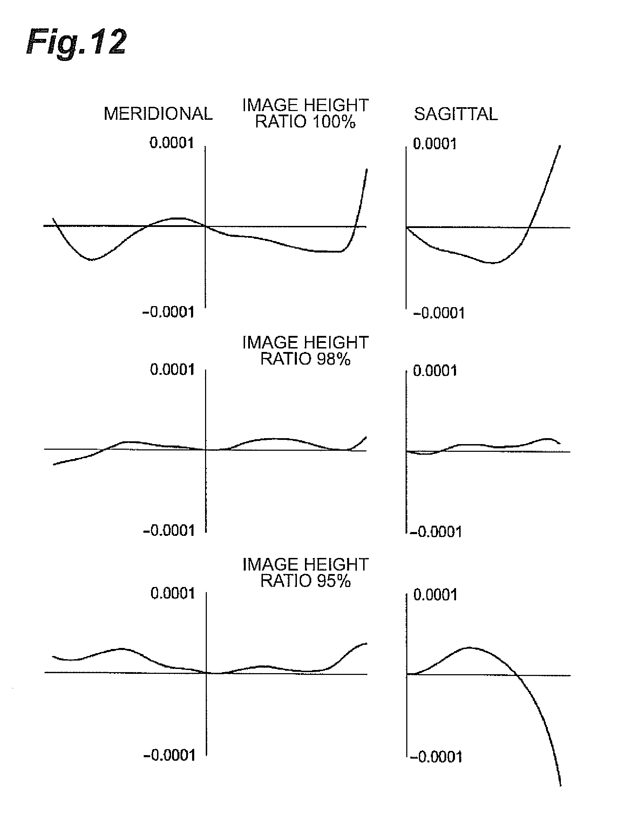

Fig. 12 is a drawing showing coma in the projection optical system of the fifth example. Fig. 12 shows the meridional coma and sagittal coma at the image height 100%, at the image height 98%, and at the image height 95%. It is apparent from the aberration diagram that in the fifth example, coma is well compensated for in the region corresponding to the effective imaging region ER. It was confirmed, though not depicted, that the aberrations other than coma, e.g., spherical aberration and distortion, were also well compensated for in the region corresponding to the effective imaging region ER.

[Example 6]

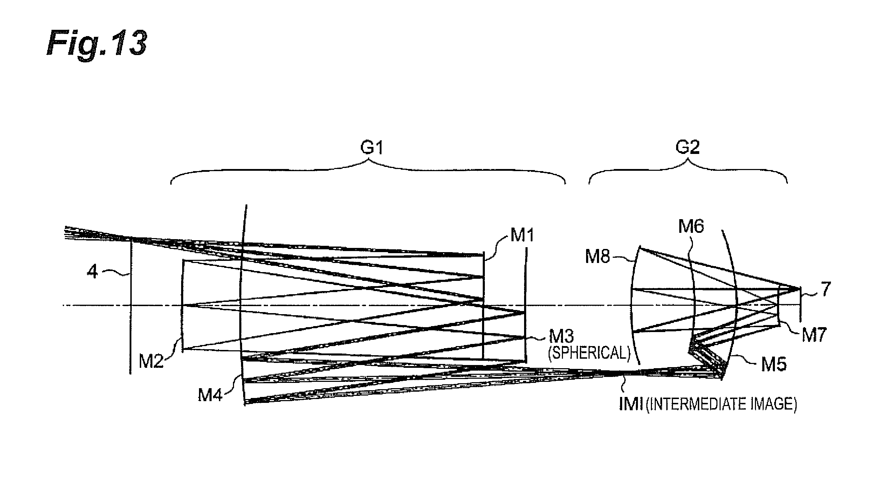

Fig. 13 is a drawing showing a configuration of the projection optical system according to the sixth example of the present embodiment. With reference to Fig. 13, the projection optical system of the sixth example is configured as follows: light from the mask 4 is successively reflected on a convex reflecting surface of the first reflecting mirror M1, on a concave reflecting surface of the second reflecting mirror M2, on a convex reflecting surface of the third reflecting mirror M3, and on a concave reflecting surface of the fourth reflecting mirror M4 to form an intermediate image of the mask pattern. Then the light from the intermediate image of the mask pattern formed via the first imaging catoptric system G1 is successively reflected on a concave reflecting surface of the fifth reflecting mirror M5, on a convex reflecting surface of the sixth reflecting mirror, on a convex reflecting surface of the seventh reflecting mirror, and on a concave reflecting surface of the eighth reflecting mirror M8 to form a reduced image (secondary image) of the mask pattern on the wafer 7. In the projection optical system of the first example the eighth reflecting mirror was comprised of a spherical surface, whereas in the present example the convex third reflecting mirror is comprised of a spherical surface. Table (6) below presents values of specifications of the projection optical system according to the sixth example.

Table (6)

(Principal Specifications)

$\lambda$ = 13.5nm

$\beta$ = ¼

NA=0.25

H0 = 156mm

$\varphi$=40mm

LX = 26 mm

LY=2mm

(Specifications of Optical Members)

| Surface Number | r | d | optical member |
|---|---|---|---|
| S0(mask surface) | | 841.07 | |
| S1 | 11039.33 | -721.07 | (1st reflecting mirror M1) |
| S2 | 1617.82 | 821.07 | (2nd reflecting mirror M2) |
| S3 | 2446.35 | -681.65 | (3rd reflecting mirror M3) spherical |
| S4 | 2000.00 | 1187.31 | (4th reflecting mirror M4) |
| S5 | -482.49 | -100.00 | (5th reflecting mirror M5) |
| S6 | -501.73 | 200.00 | (6th reflecting mirror M6) |
| S7 | 340.68 | -254.38 | (7th reflecting mirror M7) |

(continued)

| (Specifications of Optical Members) | | | |
|---|---|---|---|
| Surface Number | r | d | optical member |
| S8 | 443.92 | 407.65 | (8th reflecting mirror M8) |

(wafer surface) (Aspherical Data)

S1 Surface

$\kappa = 0.00$

A= 5.52614E-11B = 1.38370E-15C =-3.84269E-20D = 1.06804E-23E =-6.53118E-28 F= 2.16069E-32G =-3.23974E-37H = 0.00000E+00

S2 Surface

$\kappa = 0.00$

A =-1.30598E-10B=-8.72576E-16C =-9.80597E-21D = 9.76277E-25E =-1.09433E-28F= 6.36889E-33G =-1.51086E-37H = 0.00000E+00S3 SurfaceSpherical Surface

S4 Surface

$\kappa = 0.00$

A =-1.01599E-10B = 6.19470E-16C =-2.65958E-20D = 6.01905E-25E =-8.31396E-30F = 6.43013E-35G =-2.13455E-40H = 0.00000E+00

S5 Surface

$\kappa = 0.00$

A = 6.90424E-10B =-7.80937E-15C = 2.02344E-18D =-1.10078E-22E = 2.96968E-27F =-4.05905E-32G = 2.25755E-37H = 0.00000E+00

S6 Surface

$\kappa = 0.00$

A = 4.38239E-09B = 2.61724E-13C =-3.24417E-17D = 1.92286E-21E =-5.33138E-26F = 2.86023E-31G =1.03596E-35H = 0.00000E+00

S7 Surface

$\kappa = 0.00$

A = 1.21470E-08B =-8.57463E-14C = 2.81447E-17D =-5.11735E-20E = 1.93974E-23F =-4.27193E-27G = 3.97324E-31H = 0.00000E+00

S8 Surface

$\kappa = 0.00$

A= 2.47598E-10B = 1.95136E-15C = 1.44504E-20D =-1.20985E-25E = 1.74797E-29F =-6.31416E-34G = 9.33844E-39H = 0.00000E+00 (Values Corresponding to Conditions)

M$\varphi$ = 474.75 (maximum at the fourth reflecting mirror M4)

TT = 1600.0

M$\varphi$/H0 = 3.04

TT/H0 = 10.26 d1 = 841.07mm d2 = 721.07 mm d3 = 821.07 mm d1/d2 = 1.17 d3/d2 = 1.14

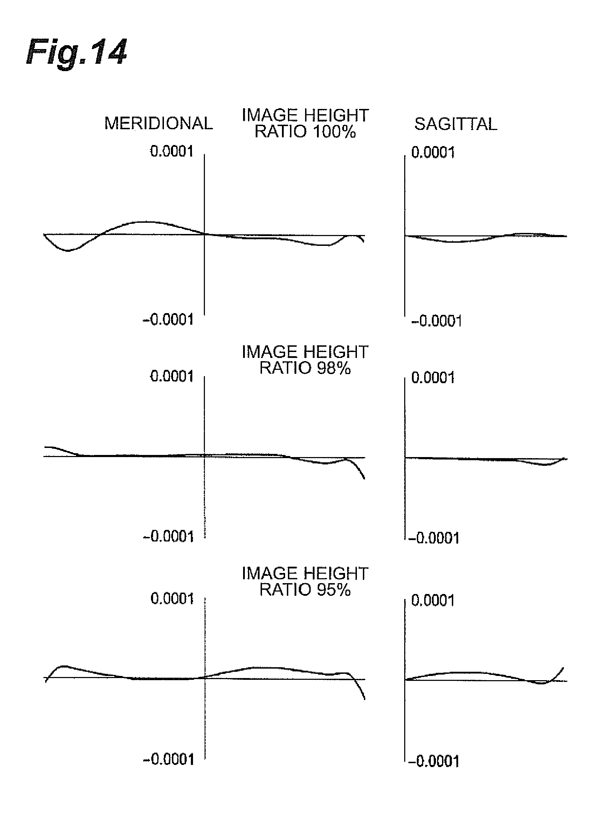

Fig. 14 is a drawing showing coma in the projection optical system of the sixth example. Fig. 14 shows the meridional coma and sagittal coma at the image height 100%, at the image height 98%, and at the image height 95%. It is apparent from the aberration diagram that in the sixth example, coma is well compensated for in the region corresponding to the effective imaging region ER. It was confirmed, though not depicted, that the aberrations other than coma, e.g., spherical aberration and distortion, were also well compensated for in the region corresponding to the effective imaging region ER.

[Example 7]

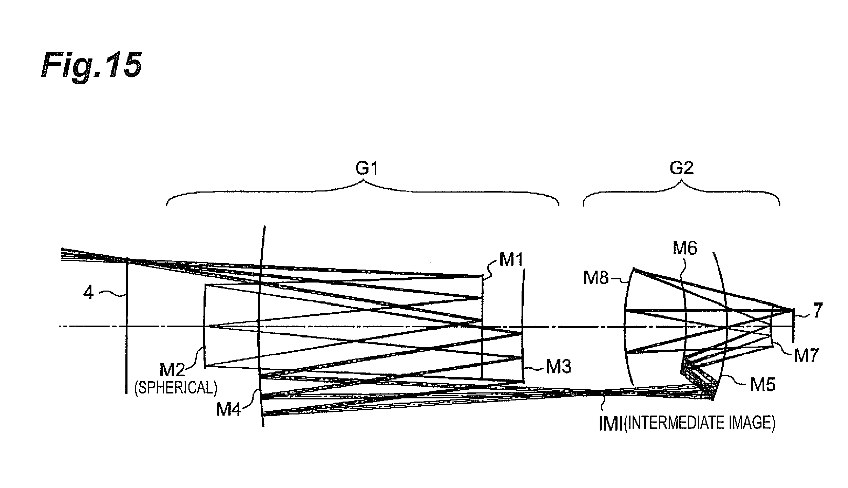

Fig. 15 is a drawing showing a configuration of the projection optical system according to the seventh example of the present embodiment. With reference to Fig. 15, the projection optical system of the seventh example is configured as follows: light from the mask 4 is successively reflected on a convex reflecting surface of the first reflecting mirror M1, on a concave reflecting surface of the second reflecting mirror M2, on a convex reflecting surface of the third reflecting mirror M3, and on a concave reflecting surface of the fourth reflecting mirror M4 to form an intermediate image of the mask pattern. Then the light from the intermediate image of the mask pattern formed via the first imaging catoptric system G1 is successively reflected on a concave reflecting surface of the fifth reflecting mirror M5, on a convex reflecting surface of the sixth reflecting mirror, on a convex reflecting surface of the seventh reflecting mirror, and on a concave reflecting surface of the eighth reflecting mirror M8 to form a reduced image (secondary image) of the mask pattern on the wafer 7. In the projection optical system of the first example the eighth reflecting mirror was comprised of a spherical surface, whereas in the present example the concave second reflecting mirror is comprised of a spherical surface. Table (7) below presents values of specifications of the projection optical system according to the seventh example.

Table (7)

(Principal Specifications)

$\lambda$ = 13.5 nm

$\beta$ = ¼

NA = 0.25

H0 = 156 mn

$\varphi$ = 40 mm

LX = 26 mm

LY=2mm

(Specifications of Optical Members Factors)

| Surface Number | r | d | Optical Member |
|---|---|---|---|
| S0(mask surface) | | 849.69 | |
| S 1 | 23309.04 | -666.38 | (1st reflecting mirror M1) |
| S2 | 1631.89 | 766.38 | (2nd reflecting mirror M2) spherical |
| S3 | 2687.92 | -635.38 | (3rd reflecting mirror M3) |
| S4 | 2000.00 | 1127.98 | (4th reflecting mirror M4) |
| S5 | -489.20 | -100.00 | (5th reflecting mirror M5) |
| S6 | -554.19 | 200.91 | (6th reflecting mirror M6) |
| S7 | 313.83 | -351.61 | (7th reflecting mirror M7) |

(continued)

| (Specifications of Optical Members Factors) | | | |
|---|---|---|---|
| Surface Number | r | d | Optical Member |
| S8 | 438.63 | 408.42 | (8th reflecting mirror M8) |

(wafer surface) (Aspherical Data) S1 Surface κ = 0.00:

A= 1.50513E-10B = 3.02143-15: C =-8.48835E-20: D =9.97470E-25: E =4.64062E-29: F=2.41448E-33: G= 4.01984E-3 8: H= 0.00000E+00 S2 Surface Spherical S3 Surface K = 0.00: A =-8.67763E-10: B = 2.06507E-15: C =-1.85462E-21: D =-1.38609E-25: E = 4.28023E-30: F =-1.70964E-35: G =-1.08125E-39: H = 0.00000E+00 S4 Surface κ = 0.00 A =-2.18287E-10: B =-4.29107E-16: C =-1.91874E-21: D = 4.25004E-26: E =-9.81542E-31: F = 1.08197E-35: G =-4.80117E-41: H = 0.00000E+00 S5 Surface κ = 0.00: A = 3.57160E-10: B =-2.19811E-14: C = 2.36995E-18: D =-1.18488E-22: E = 3.30479E-27: F =-4.93170E-32: G = 3.07879E-37: H = 0.00000E+00 S6 Surface κ = 0.00:

A = 1.33970E-09: B = 6.28995E-14: C =-8.12425E-18D = 6.77538E-22E =-3.39767E-26F = 8.85578E-31G =-8.43710E-36H = 0.00000E+00S7 Surfaceκ = 0.00A = 9.12402E-09B =-3.91177E-14C = 3.59440E-17D = 1.60493E--21E =-1.40212E-24F = 2.26670E-28: G =-1.47719E-32: H = 0.00000E+00 S8 Surface κ = 0.00:

A = 1.33040E-11: B = 2.74191E-16: C = 1.69281E-21: D = 2.77234E-26E =-9.88835E-31: F = 3.54065E-35: G=-4.92892E-40:H=0.00000E+00 (Values Corresponding to Conditionsl)

Mφ = 436.43 (maximum at the fourth reflecting mirror M4)

TT = 1600.

0Mφ/H0 = 3.04

TT/H0 = 10.26 d1 = 849.69 mm d2 = 666.38 mm d3 = 766.38 mm d1/d2 = 1.28 d3/d2 = 1.15

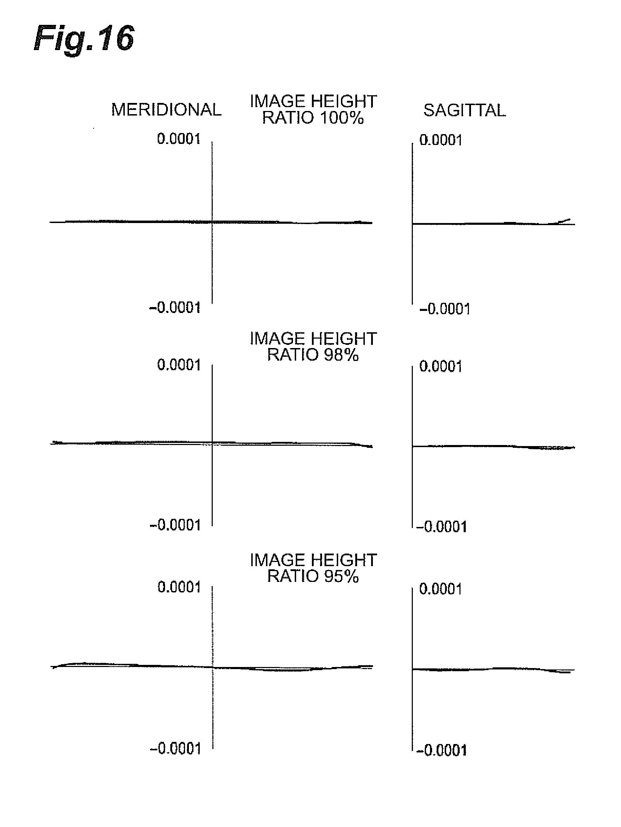

Fig. 16 is a drawing showing coma in the projection optical system of the seventh example. Fig. 16 shows the meridional coma and sagittal coma at the image height 100%, at the image height 98%, and at the image height 95%. It is apparent from the aberration diagram that in the seventh example, coma is well compensated for in the region corresponding to the effective imaging region ER. It was confirmed, though not depicted, that the aberrations other than coma, e.g., spherical aberration and distortion, were also well compensated for in the region corresponding to the effective imaging region ER.

[Example 8]

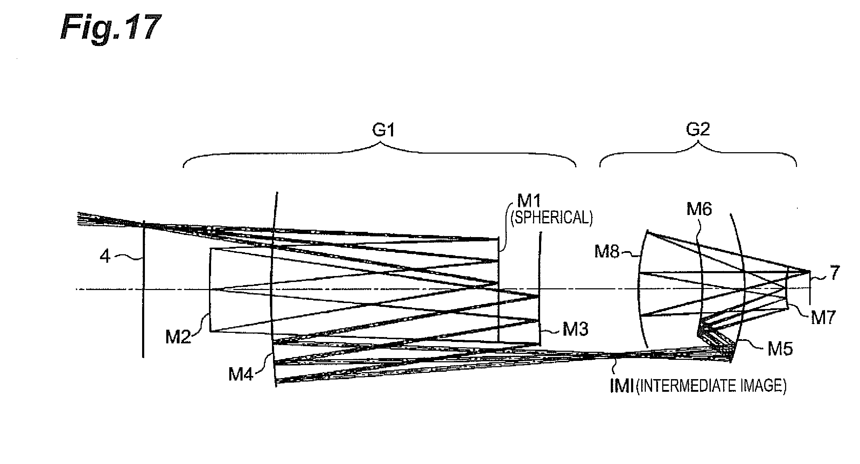

Fig. 17 is a drawing showing a configuration of the projection optical system according to the eighth example of the present embodiment. With reference to Fig. 17, the projection optical system of the eighth example is configured as follows: light from the mask 4 is successively reflected on a convex reflecting surface of the first reflecting mirror M1, on a concave reflecting surface of the second reflecting mirror M2, on a convex reflecting surface of the third reflecting mirror M3, and on a concave reflecting surface of the fourth reflecting mirror M4 to form an intermediate image of the mask pattern. Then the light from the intermediate image of the mask pattern formed via the first imaging catoptric system G1 is successively reflected on a concave reflecting surface of the fifth reflecting mirror M5, on a convex reflecting surface of the sixth reflecting mirror, on a convex reflecting surface of the seventh reflecting mirror, and on a concave reflecting surface of the eighth reflecting mirror M8 to form a reduced image (secondary image) of the mask pattern on the wafer 7. In the projection optical system of the first example the eighth reflecting mirror was comprised of a spherical surface, whereas in the present example the first reflecting mirror is comprised of a spherical surface. Table (8) below presents values of specifications of the projection optical system according to the eighth example.

Table (8)

(Principal Specifications)

$\lambda$ = 13.5 nm

$\beta$ = ¼

NA = 0.25

H0 = 156 mm

$\varphi$ = 40 mm

LX = 26 mm

LY = 2 mm

(Specificatuions of Optical Members)

| Surface Number | r | d | Optical Member |
|---|---|---|---|
| S0 (mask surface) | | 849.86 | |
| S1 | 14647.57 | -695.37 | (1st reflecting mirror M1) spherical |
| S2 | 1624.30 | 795.37 | (2nd reflecting mirror M2) |
| S3 | 2500.57 | -648.57 | (3rd reflecting mirror M3) |
| S4 | 1959.70 | 1137.61 | (4th reflecting mirror M4) |
| S5 | -518.59 | -100.36 | (5th reflecting mirror M5) |
| S6 | -652.55 | 201.53 | (6th reflecting mirror M6) |
| S7 | 305.01 | -355.04 | (7th reflecting mirror M7) |

(continued)

| (Specificatuions of Optical Members) | | | |
|---|---|---|---|
| Surface Number | r | d | Optical Member |
| S8 | 443.86 | 414.98 | (8th reflecting mirror M8) |

(wafer surface) (Aspherical Data) S1 Surface Spherical

S2 Surface

$\kappa$ = 0.00:

A =-6.19961E-11: B =-8.01064E-17: C = 7.39785E-22: D =-1.63635E-25: E = 1.61146E-29: F =-7.76550E-34: G = 1.41983E-38: H = 0.00000E+00

S3 Surface

$\kappa$ = 0.00:

A =-6.12122E-10: B =-1.16001E-16: C = 8.10748E-21: D =-5.70065E-25: E = 2.95099E-29: F =-7.54162E-34: G = 7.55756E-39: H = 0.00000E+00

S4 Surface

$\kappa$ = 0.00:

A=-1.76221E-10: B =-3.50361E-16: C =-1.35172E-21: D = 3.31221E-26: E =-8.84773E-31: F = 1.02240E-35: G =-4.59915E-41: H = 0.00000E+00

S5 Surface

$\kappa$ = 0.00:

A = 2.45960E-10: B =-2.33020E-14: C = 2.50729E-18: D =-1.26602E-22: E = 3.52881E-27: F =-5.24219E-32: G = 3.24672E-37: H = 0.00000E+00

S6 Surface

$\kappa$ = 0.00:

A = 6.48337E-10: B = 3.87553E-14: C =-3.35305E-18: D = 6.90509E-23: E = 7.76879E-27: F =-5.95487E-31: G = 1.27029E-35: H = 0.00000E+00

S7 Surface

$\kappa$ = 0.00:

A = 1.05474E-08: B = 3.44948E-13: C = 1.44739E-17: D =-3.88657E-21: E=2.06264E-24: F=-5.25423E-28: G=5.65376E-32: H= 0.00000E+00

S8 Surface

$\kappa$ = 0.00:

A= 8.95479E-11: B = 5.33820E-16: C = 2.52317E-21: D = 2.95882E-26: E=-7.88338E-32: F=-6.29084E-36: G=1.64811E-40: H= 0.00000E+00 (Values Corresponding to Conditions)

M$\varphi$ = 448.25 (maximum at the fourth reflecting mirror M4)

TT = 1600.0

M$\varphi$/H0 =2.87

TT/H0 = 10.26 d1 = 849.86 mm d2 = 695.37 mm d3 = 795.37 mm d1/d2 = 1.22 d3/d2 = 1.14

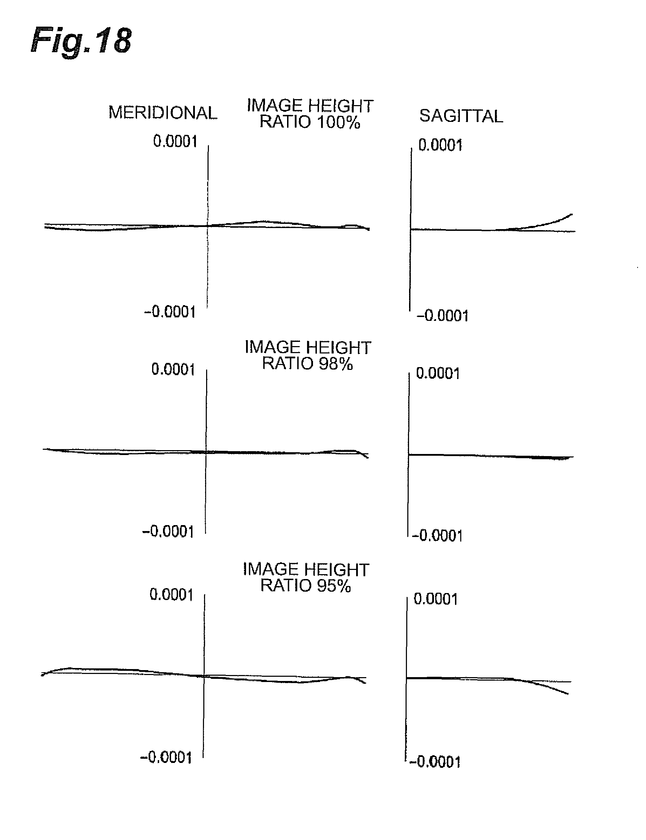

Fig. 18 is a drawing showing coma in the projection optical system of the eighth example. Fig. 18 shows the meridional coma and sagittal coma at the image height 100%, at the image height 98%, and at the image height 95%. It is apparent from the aberration diagram that in the eighth example, coma is well compensated for in the region corresponding to the effective imaging region ER. It was confirmed, though not depicted, that the aberrations other than coma, e.g., spherical aberration and distortion, were also well compensated for in the region corresponding to the effective imaging region ER.

[Example 9]

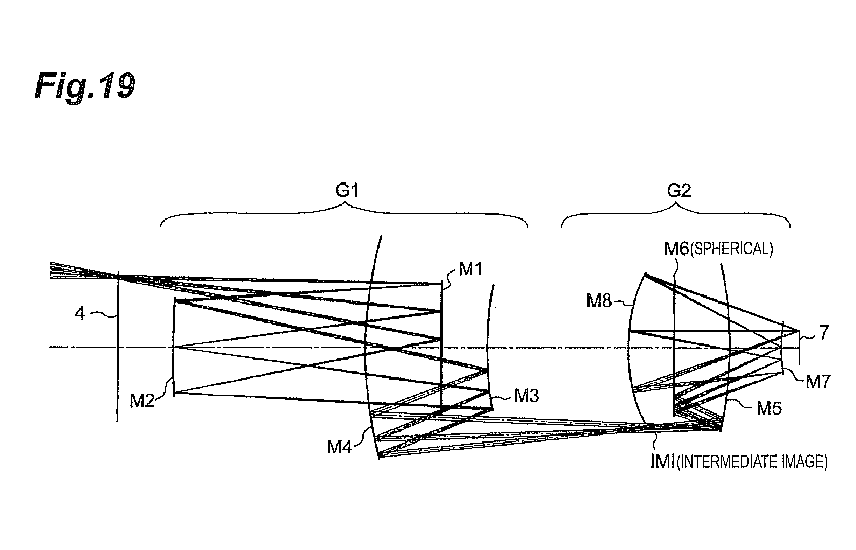

Fig. 19 is a drawing showing a configuration of the projection optical system according to the ninth example of the present embodiment. With reference to Fig. 19, the projection optical system of the ninth example is configured as follows: light from the mask 4 is successively reflected on a concave reflecting surface of the first reflecting mirror M1, on a concave reflecting surface of the second reflecting mirror M2, on a convex reflecting surface of the third reflecting mirror M3, and on a concave reflecting surface of the fourth reflecting mirror M4 to form an intermediate image of the mask pattern. Then the light from the intermediate image of the mask pattern formed via the first imaging catoptric system G1 is successively reflected on a concave reflecting surface of the fifth reflecting mirror M5, on a concave reflecting surface of the sixth reflecting mirror, on a convex reflecting surface of the seventh reflecting mirror, and on a concave reflecting surface of the eighth reflecting mirror M8 to form a reduced image (secondary image) of the mask pattern on the wafer 7. In the projection optical system of the first example the eighth reflecting mirror was comprised of a spherical surface, whereas in the present example the convex sixth reflecting mirror is comprised of a spherical surface. Table (9) below presents values of specifications of the projection optical system according to the ninth example.

Table (9)

(Principal Specifications)

$\lambda$ = 13.5 nm

$\beta$=¼

NA=0.35

H0 = 156 mm

$\varphi$ = 40 mm

LX = 26 mm

LY=2mm

(Specifications of Optical Members)

| Surface Number | r | d | Optical Member |
|---|---|---|---|
| S0 (mask surface) | | 709.93 | |
| S1 | -4433.41 | -589.93 | (1st reflecting mirror M1) |
| S2 | 1327.91 | 689.93 | (2nd reflecting mirror M2) |
| S3 | 677.63 | -268.10 | (3rd reflecting mirror M3) |
| S4 | 891.30 | 805.69 | (4th reflecting mirror M4) |
| S5 | -978.07 | -123.10 | (5th reflecting mirror M5) |
| S6 | 24591.30 | 235.57 | (6th reflecting mirror M6) spherical |
| S7 | 237.26 | -335.57 | (7th reflecting mirror M7) |

(continued)

| Surface Number | r | d | Optical Member |
|---|---|---|---|
| S8 | 404.70 | 375.57 | (8th reflecting mirror M8) |

(wafer surface) (Aspherical Data)

S1 Surface

$\kappa = 0.00$

A= 1.37230E-09: B =-2.34495E-14: C = 3.54540E-19: D =-4.91321 E-24: E = 1.12584E-28: F =-3.55914E-33: G = 5.08482E-38: H = 0.00000E+00S2 Surface$\kappa$ = 0.00A=-7.38075E-11B =-1.87124E-16C =-5.25573E-20: D = 9.80006E-24: E =-1.03334E-27: F = 5.88491E-32: G =-1.37947E-36: H = 0.00000E+00

S3 Surface

$\kappa = 0.00$

A =-2.65468E-09: B =-2.02936E-15: C = 1.51722E-19: D =-1.06845E-23: E = 3.88202E-28: F =-9.62486E-33: G = 1.1336E-37: H = 0.00000E+00

S4 Surface

$\kappa=0.00$:

A =-2.71226E-10: B =-3.34206E-15: C = 8.03920E-20: D=-1.68936E-24: E = 2.12370E-29: F =-1.50533E-34: G = 4.47804E-40: H = 0.00000E+00

S5 Surface

$\kappa = 0.00$:

A = 3.78564E-10: B =-2.98239E-14: C = 3.02836E-19: D = 2.29877E-23: E =-9.76811E-28: F = 1.56167E-32: G =-9.39373E-38: H = 0.00000E+00 S6 Surface Spherical

S7 Surface

$\kappa = 0.00$

A=-4.86887E-09: B = 2.32977E-12: C =-2.42965E-17: D = 1.78170E-20: E =-1.18048E-23: F = 3.22917E-27: G =-3.03495E-31: H = 0.00000E+00

S8 Surface

$\kappa=0.00$:

A = 9.65841E-11: B = 7.68361E-16: C = 3.9SS91E-21: D = 2.59918E-26: E = 2.07120E-30: F =-7.39442: E-3G = 9.08142E-40: H = 0.00000E+0 (Values Corresponding to Conditions)

M$\varphi$ = 488.42 (maximum at the fourth reflecting mirror M4)

TT = 1600.0

M$\varphi$/H0 = 2.87

TT/H0 = 10.26 d1 = 709.93 mm d2 = 589.93 mm d3 = 689.93 mm d1/d2 = 1.20 d3/d2 = 1.17

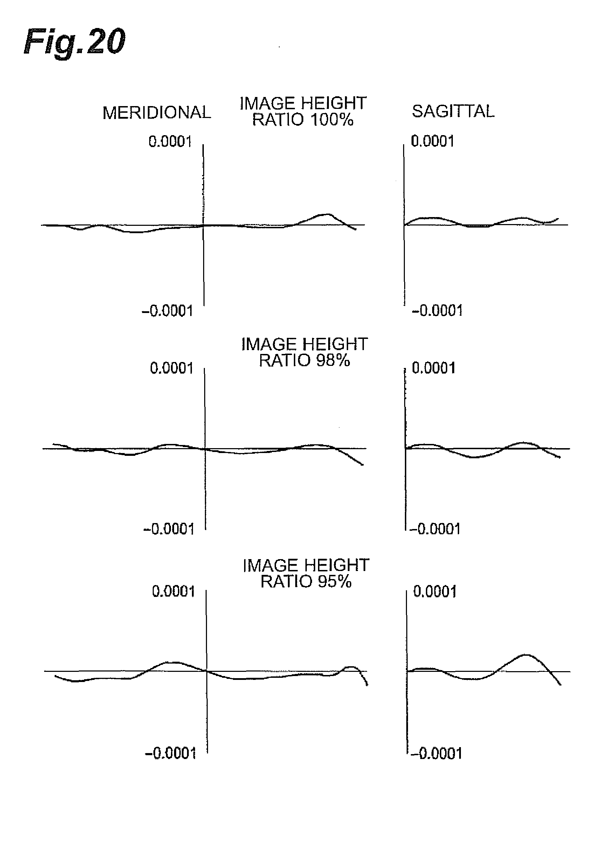

Fig. 20 is a drawing showing coma in the projection optical system of the ninth example. Fig. 20 shows the meridional coma and sagittal coma at the image height 100%, at the image height 98%, and at the image height 95%. It is apparent from the aberration diagram that in the ninth example, coma is well compensated for in the region corresponding to the effective imaging region ER. It was confirmed, though not depicted, that the aberrations other than coma, e.g., spherical aberration and distortion, were also well compensated for in the region corresponding to the effective imaging region ER.

In each of the foregoing examples, as described above, the projection optical system is able to ensure the image-side numerical aperture of 0.25-0.35 for the laser plasma X-rays with the wavelength of 13.5nm and the arcuate effective exposure region of 26 mm x 2 mm well compensated for aberrations on the wafer 7. Therefore, the pattern of the mask 4 can be transferred in the high resolution of not more than 0.1 $\mu$m in each exposure region, for example, in the size of 26 mm $\times$ 66 mm on the wafer 7 by scanning exposure.

In each of the foregoing examples, the effective diameter of the largest fourth reflecting mirror M4 is in the order of about 400 mm to 520 mm and is thus controlled well to a small level. Each example is thus designed to suppress increase in the size of the reflecting mirrors and to achieve reduction in the scale of the optical system. Since in the present invention the distance (object-image distance) TT from the object (reticle) to the image (wafer) is determined to satisfy the range of 1350 mm to 1800 mm, the optical system maintains good optical performance while the size thereof is prevented from increasing.

In the exposure apparatus of the foregoing embodiment, when either of the surfaces of the fifth reflecting mirror M5 and the sixth reflecting mirror M6, which are the reflecting mirrors with the effective region relatively small, is formed in the spherical shape, it becomes easy to fabricate a high-accuracy reflecting optical system. In the exposure apparatus of the foregoing embodiment, when either of the surfaces of the sixth reflecting mirror M6 and the seventh reflecting mirror M7 with angles of incidence of rays relatively large is formed in the spherical shape, it becomes easy to fabricate the high-accuracy reflecting optical system.

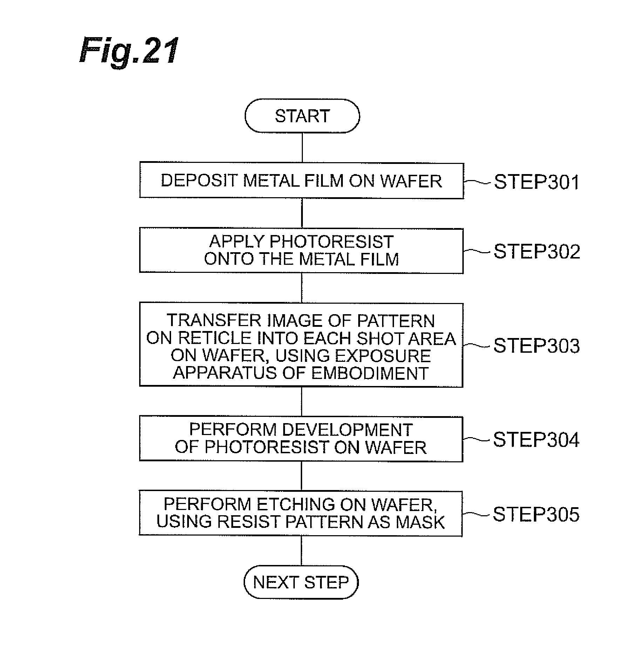

The exposure apparatus of the above embodiment can be used to fabricate micro devices (semiconductor devices, image pickup devices, liquid-crystal display devices, thin-film magnetic heads, etc.) by illuminating a mask by the illumination system (illumination step) and projecting a pattern to be transferred, formed in the mask, onto a photosensitive substrate by the projection optical system (exposure step). An example of a technique of forming a predetermined circuit pattern in a wafer or the like as a photosensitive substrate with the exposure apparatus of the present embodiment to obtain semiconductor devices as micro devices will be described below with reference to the flowchart of Fig.21.

The first step 301 in Fig. 21 is to deposit a metal film on each wafer in one lot. The next step 302 is to apply a photoresist onto the metal film on each wafer in the lot. The subsequent step 303 is to sequentially transfer an image of a pattern on the mask into each shot area on each wafer in the lot through the projection optical system, using the exposure apparatus of the foregoing embodiment.

The subsequent step 304 is to perform development of the photoresist on each wafer in the lot and the subsequent step 305 is to perform etching on each wafer in the lot, using the resist pattern as a mask, and thereby to form a circuit pattern corresponding to the pattern on the mask, in each shot area on each wafer. Subsequent steps include formation of circuit patterns in upper layers, and others, thereby fabricating devices such as semiconductor devices. The above-described semiconductor device fabrication method permits us to obtain semiconductor devices with extremely fine circuit patterns at high throughput.

The aforementioned embodiment was arranged to use the laser plasma X-ray source as a light source for supplying X-rays, but, without having to be limited to this, it is also possible to use, for example, synchrotron orbit radiation (SOR) light as X-rays.

The foregoing embodiment was the application of the present invention to the exposure apparatus having the light source for supplying X-rays, but, without having to be limited to this, the present invention can also be applied to exposure apparatus having the light source for supplying light of the wavelengths other than X-rays.

Furthermore, the aforementioned embodiment was the application of the present invention to the projection optical system in the exposure apparatus, but, without having to be limited to this, the present invention can also be applied to other general projection optical systems.

**Claims**

1. A reflective projection optical system comprising eight reflecting mirrors and adapted to form a reduced image of a first surface on a second surface, the reflective projection optical system comprising: a first imaging catoptric system for forming an intermediate image of the first surface; and a second imaging catoptric system for forming an image of the intermediate image on the second surface;
   wherein the first imaging catoptric system has a first reflecting mirror M1, a second reflecting mirror M2, a third reflecting mirror M3, and a fourth reflecting mirror M4 in an order of incidence of light from the first surface side;
   wherein the second imaging catoptric system has a fifth reflecting mirror M5, a sixth reflecting mirror M6, a seventh reflecting mirror M7, and an eighth reflecting mirror M8 in an order of incidence of light from the first surface side, wherein at least one reflecting surface among the eight reflecting mirrors is comprised of a spherical surface, and
   wherein the other reflecting surfaces are comprised of aspherical surfaces.

2. The reflective projection optical system according to claim 1, wherein a reflecting surface of the fourth reflecting mirror M4 or/and a reflecting surface of the fifth reflecting mirror M5 are comprised of spherical surfaces.

3. The reflective projection optical system according to claim 1 or 2, wherein among the eight reflecting mirrors, a reflecting surface of a reflecting mirror with a relatively high requirement for manufacturing error is comprised of a spherical surface.

4. The reflective projection optical system according to any one of claims 1 to 3, wherein among the eight reflecting mirrors, a reflecting mirror with a relatively large angle of incidence of a beam to the reflecting surface is comprised of a spherical surface.

5. The reflective projection optical system according to any one of claims 1 to 4, wherein among the eight reflecting mirrors, a reflecting mirror with a relatively small area where a beam contributing to imaging is reflected on the reflecting surface, is comprised of a spherical surface.

6. The reflective projection optical system according to any one of claims 1 to 5, wherein the first imaging catoptric system is comprised of a reflecting mirror, a concave mirror, a convex mirror, and a concave mirror in order from the object side.

7. The reflective projection optical system according to any one of claims 1 to 6, wherein the second imaging catoptric system is comprised of a concave mirror, a reflecting mirror, a convex mirror, and a concave mirror in order from the object side.

8. The reflective projection optical system according to any one of claims 1 to 7, wherein when a distance from the first surface to the first reflecting mirror M1 is defined as d1, the distance d1 satisfies the following condition:

$$700\,\mathrm{mm} \leq \mathrm{d1}.$$

9. The reflective projection optical system according to any one of claims 1 to 8, wherein when a distance from the first reflecting mirror M1 to the second reflecting mirror M2 is defined as d2, the distance d2 satisfies the following condition:

$$450\,\mathrm{mm} \leq \mathrm{d2}.$$

10. The reflective projection optical system according to any one of claims 1 to 9, wherein when a distance from the second reflecting mirror M2 to the third reflecting mirror M3 is defined as d3, the distance d3 satisfies the following condition:

$$570\,\mathrm{mm} \leq \mathrm{d3}.$$

11. The reflective projection optical system according to any one of claims 1 to 10, wherein when d1 represents a distance from the first surface to the first reflecting mirror M1 and when d2 represents a distance from the first reflecting mirror M1 to the second reflecting mirror M2, a position of the second reflecting mirror M2 satisfies the following condition:

$$1 < \mathrm{d1/d2} < 1.9.$$

12. The reflective projection optical system according to any one of claims 1 to 11, wherein when d2 represents a distance from the first reflecting mirror M1 to the second reflecting mirror M2 and when d3 represents a distance from the second reflecting mirror M2 to the third reflecting mirror M3, a position of the third reflecting mirror M3 satisfies the following condition:

$$1.1 < \mathrm{d3/d2} < 1.5.$$

13. The reflective projection optical system according to any one of claims 1 to 12, wherein when a maximum effective diameter of the reflecting mirrors is defined as Mφ, the maximum effective diameter Mφ satisfies the following condition:

$$400 \text{ mm} < M\varphi < 600 \text{ mm}.$$

14. The reflective projection optical system according to any one of claims 1 to 13, wherein when a maximum effective diameter of the reflecting mirrors is defined as Mφ and when a maximum object height on the first surface is defined as H0, a ratio Mφ/H0 satisfies the following condition:

$$2 < M\varphi/H0 < 4.$$

15. The reflective projection optical system according to any one of claims 1 to 14, wherein when an axial distance between the first surface and the second surface is defined as TT, the axial distance TT satisfies the following condition:

$$1350 \text{ mm} < TT < 1800 \text{ mm}.$$

16. The reflective projection optical system according to any one of claims 1 to 15, wherein when an axial distance between the first surface and the second surface is defined as TT and when a maximum object height on the first surface is defined as H0, a ratio TT/H0 satisfies the following condition:

$$8 < TT/H0 < 15.$$

17. The reflective projection optical system according to any one of claims 1 to 16, wherein an image-side numerical aperture NA is at least 0.20.

18. An exposure apparatus comprising: an illumination system for illuminating a mask set on the first surface; and the reflective projection optical system as defined in any one of claims 1 to 17, for projecting a pattern of the mask onto a photosensitive substrate set on the second surface, to effect exposure thereof.

19. The exposure apparatus according to claim 18, wherein the illumination system comprises a light source for supplying X-rays as exposure light, and wherein the projection exposure of the pattern of the mask is effected on the photosensitive substrate, with relative movement of the mask and the photosensitive substrate to the reflective projection optical system.

20. A reflective projection optical system comprising at least eight reflecting mirrors and adapted to form a reduced image of a first surface on a second surface, wherein among said at least eight reflecting mirrors, a reflecting mirror with a relatively large angle of incidence of a beam to the reflecting surface is comprised of a spherical surface.

21. A reflective projection optical system comprising at least eight reflecting mirrors and adapted to form a reduced image of a first surface on a second surface, wherein among said at least eight reflecting mirrors, a reflecting mirror with a relatively small area where a beam contributing to imaging is reflected on the reflecting surface, is comprised of a spherical surface.

# *Fig.1*

# *Fig.2*

Fig.3

# Fig.4

MERIDIONAL IMAGE HEIGHT RATIO 100% SAGITTAL

0.0001

-0.0001

0.0001

-0.0001

IMAGE HEIGHT RATIO 98%

0.0001

-0.0001

0.0001

-0.0001

IMAGE HEIGHT RATIO 95%

0.0001

-0.0001

0.0001

-0.0001

*Fig.5*

G1

G2

M6

M8

M1

4

7

M2

M7
(SPHERICAL)

M3

M5

M4

IMI (INTERMEDIATE IMAGE)

# Fig.6

MERIDIONAL     IMAGE HEIGHT RATIO 100%     SAGITTAL

0.0001                                0.0001

−0.0001                               −0.0001

IMAGE HEIGHT RATIO 98%

0.0001                                0.0001

−0.0001                               −0.0001

IMAGE HEIGHT RATIO 95%

0.0001                                0.0001

−0.0001                               −0.0001

Fig.7

# Fig.8

MERIDIONAL     IMAGE HEIGHT     SAGITTAL
RATIO 100%

0.0001                0.0001

−0.0001            −0.0001

IMAGE HEIGHT
RATIO 98%

0.0001                0.0001

−0.0001            −0.0001

IMAGE HEIGHT
RATIO 95%

0.0001                0.0001

−0.0001            −0.0001

## Fig.9

G1

G2

M1

M6

M8

4

M2

M3

M4

M5
(SPHERICAL)

IMI(INTERMEDIATE IMAGE)

7

M7

# *Fig.10*

MERIDIONAL    IMAGE HEIGHT    SAGITTAL
RATIO 100%

IMAGE HEIGHT
RATIO 98%

IMAGE HEIGHT
RATIO 95%

Fig.11

# Fig.12

MERIDIONAL  IMAGE HEIGHT RATIO 100%  SAGITTAL

IMAGE HEIGHT RATIO 98%

IMAGE HEIGHT RATIO 95%

Fig.13

EP 1 811 327 A1

EP 1 811 327 A1

# Fig.14

MERIDIONAL  IMAGE HEIGHT RATIO 100%  SAGITTAL

IMAGE HEIGHT RATIO 98%

IMAGE HEIGHT RATIO 95%

43

*Fig.15*

G1

G2

M1

M8

M6

7

4

M2
(SPHERICAL)

M3

M4

M5

M7

IMI(INTERMEDIATE IMAGE)

EP 1 811 327 A1

# Fig.16

MERIDIONAL | IMAGE HEIGHT RATIO 100% | SAGITTAL

0.0001

−0.0001

IMAGE HEIGHT RATIO 98%

0.0001

−0.0001

IMAGE HEIGHT RATIO 95%

0.0001

−0.0001

Fig.17

EP 1 811 327 A1

# Fig.18

MERIDIONAL    IMAGE HEIGHT RATIO 100%    SAGITTAL

0.0001           0.0001

-0.0001         -0.0001

IMAGE HEIGHT RATIO 98%

0.0001           0.0001

-0.0001         -0.0001

IMAGE HEIGHT RATIO 95%

0.0001           0.0001

-0.0001         -0.0001

*Fig.19*

G1         G2

M6(SPHERICAL)

M1

M8

4

7

M2

M3

M7

M4

M5

IMI(INTERMEDIATE IMAGE)

EP 1 811 327 A1

# Fig.20

MERIDIONAL IMAGE HEIGHT RATIO 100% SAGITTAL

IMAGE HEIGHT RATIO 98%

IMAGE HEIGHT RATIO 95%

# Fig.21

```
            ┌──────────────┐
            │    START     │
            └──────────────┘
                   │
    ┌──────────────────────────────────┐
    │  DEPOSIT METAL FILM ON WAFER      │── STEP301
    └──────────────────────────────────┘
                   │
    ┌──────────────────────────────────┐
    │         APPLY PHOTORESIST          │
    │       ONTO THE METAL FILM          │── STEP302
    └──────────────────────────────────┘
                   │
    ┌──────────────────────────────────┐
    │    TRANSFER IMAGE OF PATTERN       │
    │ ON RETICLE INTO EACH SHOT AREA     │── STEP303
    │   ON WAFER, USING EXPOSURE         │
    │  APPARATUS OF EMBODIMENT           │
    └──────────────────────────────────┘
                   │
    ┌──────────────────────────────────┐
    │     PERFORM DEVELOPMENT            │
    │   OF PHOTORESIST ON WAFER          │── STEP304
    └──────────────────────────────────┘
                   │
    ┌──────────────────────────────────┐
    │   PERFORM ETCHING ON WAFER,        │
    │ USING RESIST PATTERN AS MASK       │── STEP305
    └──────────────────────────────────┘
                   │
            ┌──────────────┐
            │  NEXT STEP   │
            └──────────────┘
```

## INTERNATIONAL SEARCH REPORT

| | International application No. |
|---|---|
| | PCT/JP2005/020267 |

| A. CLASSIFICATION OF SUBJECT MATTER |
|---|
| *G02B17/00*(2006.01) |

According to International Patent Classification (IPC) or to both national classification and IPC

| B. FIELDS SEARCHED |
|---|
| Minimum documentation searched (classification system followed by classification symbols) |
| *G02B17/00*(2006.01) |

Documentation searched other than minimum documentation to the extent that such documents are included in the fields searched

| Jitsuyo Shinan Koho | 1922-1996 | Jitsuyo Shinan Toroku Koho | 1996-2006 |
|---|---|---|---|
| Kokai Jitsuyo Shinan Koho | 1971-2006 | Toroku Jitsuyo Shinan Koho | 1994-2006 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y<br>A | JP 2002-162566 A (Nikon Corp.),<br>07 June, 2002 (07.06.02),<br>Full text; all drawings<br>& US 2002/0129328 A1 | 1-10,12-21<br>11 |
| Y<br>A | JP 2002-139672 A (Carl-Zeiss-Stiftung<br>trading as Carl Zeiss),<br>17 May, 2002 (17.05.02),<br>Full text; all drawings<br>& US 6710917 B2          & EP 1199590 A1<br>& WO 2002/033467 A1 | 1-10,12-21<br>11 |

| ☐ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 19 January, 2006 (19.01.06) | 31 January, 2006 (31.01.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**EP 1 811 327 A1**

## REFERENCES CITED IN THE DESCRIPTION

### Patent documents cited in the description

- JP 9211332 A
- US 5815310 A
- JP 2002139672 A
- US 6710917 B